(19) Europäisches Patentamt
European Patent Office
Office européen des brevets

(11) **EP 2 913 185 B1**

(12) **EUROPEAN PATENT SPECIFICATION**

(45) Date of publication and mention
of the grant of the patent:
**27.07.2016 Bulletin 2016/30**

(51) Int Cl.:
**B41C 1/05** *(2006.01)*          **B41N 1/12** *(2006.01)*
**G03F 7/36** *(2006.01)*          **G03F 7/20** *(2006.01)*
**G03F 7/032** *(2006.01)*          **G03F 7/033** *(2006.01)*
**G03F 7/035** *(2006.01)*

(21) Application number: **15152654.8**

(22) Date of filing: **27.01.2015**

(54) **Resin composition for laser engraving, flexographic printing plate precursor for laser engraving and process for producing same, and flexographic printing plate and process for making same**

Harzzusammensetzung für Lasergravierung, Flexodruckplattenvorläufer für Lasergravierung und Verfahren zu dessen Herstellung sowie Flexodruckplatte und Verfahren zu deren Herstellung

Composition de résine pour gravure au laser, précurseur de plaque d'impression flexographique pour gravure au laser, son procédé de production, plaque d'impression flexographique et procédé de fabrication associé

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **27.02.2014 JP 2014036711
05.12.2014 JP 2014246649**

(43) Date of publication of application:
**02.09.2015 Bulletin 2015/36**

(73) Proprietor: **Fujifilm Corporation
Minato-ku
Tokyo 106-8620 (JP)**

(72) Inventors:
• **Sugasaki, Atsushi
Shizuoka (JP)**
• **Shirakawa, Masato
Shizuoka (JP)**

(74) Representative: **Hoffmann Eitle
Patent- und Rechtsanwälte PartmbB
Arabellastraße 30
81925 München (DE)**

(56) References cited:
**EP-A1- 2 402 818          EP-A1- 2 597 108
WO-A1-2005/085953          WO-A1-2013/016044**

**Description**

The present invention relates to a resin composition for laser engraving, a flexographic printing plate precursor for laser engraving and a process for producing the same, and a flexographic printing plate and a process for making the same.

A large number of so-called "direct engraving CTP methods", in which a relief-forming layer is directly engraved by means of a laser are proposed. In the method, a laser light is directly irradiated to a flexographic printing plate precursor to cause thermal decomposition and volatilization by photothermal conversion, thereby forming a concave part. Differing from a relief formation using an original image film, the direct engraving CTP method can control freely relief shapes. Consequently, when such image as an outline character is to be formed, it is also possible to engrave that region deeper than other regions, or, in the case of a fine halftone dot image, it is possible, taking into consideration resistance to printing pressure, to engrave while adding a shoulder. With regard to the laser for use in the method, a high-power carbon dioxide laser is generally used. In the case of the carbon dioxide laser, all organic compounds can absorb the irradiation energy and convert it into heat. On the other hand, inexpensive and small-sized semiconductor lasers have been developed, wherein, since they emit visible lights and near infrared lights, it is necessary to absorb the laser light and convert it into heat.

As a flexographic printing plate, those described in JP-A-2007-272080 (JP-A denotes a Japanese unexamined patent application publication) is known.

From EP2597108 A a resin composition for laser engraving and a corresponding flexographic printing plate precursor for laser engraving is disclosed, said composition comprising spherical, porous silica particles among the components. Furthermore, WO2013/016044 A discloses laser-engraveable compositions and flexographic printing precursors, wherein the laser-engraveable resin compositions contain chemically crosslinked organic porous particles; said porous particles can include an infrared radiation absorber.

It is an object of the present invention to provide a flexographic printing plate precursor for laser engraving that can give a flexographic printing plate having excellent printing durability and that is excellent in terms of film surface state, engraving sensitivity, and rinsing properties for engraving residue, a process for producing same, and a process for making a flexographic printing plate.

Furthermore, it is another object of the present invention to provide a resin composition for laser engraving that is suitably used for such a printing plate precursor.

The objects of the present invention have been attained by <1>, <17> to <20> and <22> below. They are listed together with <2> to <16> and <21>, which are preferred embodiments.

<1> A resin composition for laser engraving, comprising as Component A hollow crosslinked particles comprising in a polymer layer a crosslinked polymer comprising a (meth)acrylic acid ester-derived monomer unit and/or a styrene-derived monomer unit, as Component B a binder polymer, as Component C a peroxide, and as Component D a photothermal conversion agent,

<2> the resin composition for laser engraving according to <1>, wherein Component A has a content of 15 to 60 mass% relative to the total mass of the solids content of the resin composition for laser engraving,

<3> the resin composition for laser engraving according to <1> or <2>, wherein it comprises as Component E substantially none of a polymerizable compound,

<4> the resin composition for laser engraving according to any one of <1> to <3>, wherein Component A has a volume-average particle size of primary particles of 0.01 μm to 50 μm,

<5> the resin composition for laser engraving according to any one of <1> to <4>, wherein Component A is of at least one type of hollow crosslinked particles selected from the group consisting of MHB-R and M-600 manufactured by Matsumoto Yushi Seiyaku Co., Ltd. and SX866 (A), SX868 (B), SX8782 (A), and SX8782 (P) manufactured by JSR,

<6> the resin composition for laser engraving according to any one of <1> to <4>, wherein the crosslinked polymer of which Component A is comprised is a copolymer of divinylbenzene and a polyvalent (meth)acrylic acid ester compound or a copolymer of a polyvalent (meth)acrylic acid ester compound and a monovalent (meth)acrylic acid ester compound,

<7> the resin composition for laser engraving according to any one of <1> to <6>, wherein Component A has a content of 3 to 60 mass% relative to the total mass of the solids content of the resin composition for laser engraving,

<8> the resin composition for laser engraving according to any one of <1> to <7>, wherein Component B is a polymer having a conjugated diene-based hydrocarbon-derived monomer unit,

<9> the resin composition for laser engraving according to any one of <1> to <8>, wherein Component B is a polymer having a butadiene- and/or isoprene-derived monomer unit,

<10> the resin composition for laser engraving according to any one of <1> to <9>, wherein Component B is a plastomer at 20°C,

<11> the resin composition for laser engraving according to any one of <1> to <10>, wherein Component B has a weight-average molecular weight of at least 1,000 but no greater than 3,000,000,

<12> the resin composition for laser engraving according to any one of <1> to <11>, wherein Component B has a content of 50 to 95 mass% relative to the total mass of the solids content of the resin composition for laser engraving,

<13> the resin composition for laser engraving according to any one of <1> to <12>, wherein Component C is an organic peroxide,

<14> the resin composition for laser engraving according to any one of <1 > to <13>, wherein Component C has a content of at least 0.01 mass% but no greater than 30 mass% relative to the total mass of the solids content of the resin composition for laser engraving,

<15> the resin composition for laser engraving according to any one of <1 > to <14>, wherein Component D is carbon black,

<16> the resin composition for laser engraving according to any one of <1 > to <15>, wherein Component D has a content of 0.01 to 30 mass% relative to the total mass of the solids content of the resin composition for laser engraving,

<17> a flexographic printing plate precursor for laser engraving comprising a relief-forming layer comprising the resin composition for laser engraving according to any one of <1> to <16>,

<18> a flexographic printing plate precursor for laser engraving comprising a crosslinked relief-forming layer formed by crosslinking by means of heat a relief-forming layer comprising the resin composition for laser engraving according to any one of <1> to <16>,

<19> a process for producing a flexographic printing plate precursor for laser engraving, comprising a kneading step of kneading the resin composition for laser engraving according to any one of <1> to <16>, a layer formation step of forming the kneaded material obtained into a sheet shape to thus form a relief-forming layer, and a crosslinking step of crosslinking by means of heat the relief-forming layer to thus give a flexographic printing plate precursor having a crosslinked relief-forming layer,

<20> a process for making a flexographic printing plate, comprising a step of preparing the flexographic printing plate precursor for laser engraving according to <17> or <19> or a flexographic printing plate precursor for laser engraving produced by the production process according to <19>, and an engraving step of laser-engraving the relief-forming layer or the crosslinked relief-forming layer to thus form a relief layer,

<21> the process for making a flexographic printing plate according to <20>, wherein it further comprises, subsequent to the engraving step, a rinsing step of rinsing the crosslinked relief layer surface using an aqueous rinsing liquid,

<22> a flexographic printing plate obtained by the process for making a flexographic printing plate according to <20> or <21>.

In accordance with the present invention, there can be provided a flexographic printing plate precursor for laser engraving that can give a flexographic printing plate having excellent printing durability and that is excellent in terms of film surface state, engraving sensitivity, and rinsing properties for engraving residue, a process for producing same, and a process for making a flexographic printing plate.

Furthermore, in accordance with the present invention, there can be provided a resin composition for laser engraving that is suitably used for such a printing plate precursor.

The content of the present invention is explained in detail below. The explanation of constituent features given below is based on representative embodiments of the present invention in some cases, but the present invention should not be construed as being limited by such embodiments.

In the present invention, a numerical range denoted by 'to' is used to mean a numerical range that includes lower limit and upper limit numerical values before and after the 'to'.

Furthermore, in the present invention, 'hollow crosslinked particles comprising in a polymer layer a crosslinked polymer comprising a (meth)acrylic acid ester-derived monomer unit and/or a styrene-derived monomer unit', etc. is also called simply 'Component A', etc.

In the present invention, 'parts by mass' and 'mass%' have the same meanings as 'parts by weight' and 'wt%' respectively.

Moreover, in the present invention, a combination of preferred embodiments is a more preferred embodiment.

(Resin composition for laser engraving)

The resin composition for laser engraving of the present invention (hereinafter, also called simply a 'resin composition' or a 'composition') comprises (Component A) hollow crosslinked particles comprising in a polymer layer a crosslinked polymer comprising a (meth)acrylic acid ester-derived monomer unit and/or a styrene-derived monomer unit (hereinafter, also called a 'specific hollow crosslinked particles'), (Component B) a binder polymer, (Component C) a peroxide, and (Component D) a photothermal conversion agent.

Furthermore, the resin composition for laser engraving of the present invention may be used suitably in thermal molding since it has excellent stability toward heat.

Moreover, the resin composition for laser engraving of the present invention preferably comprises substantially none of (Component E) a polymerizable compound. Comprising substantially none means comprising none at all or having a content of less than 2 mass%.

Furthermore, the total content of Component A to Component D in the total solids content of the resin composition for laser engraving of the present invention is preferably at least 80 mass%, more preferably at least 90 mass%, yet more preferably at least 95 mass%, and particularly preferably at least 98 mass%. The total solids content referred to here means one obtained by removing volatile components such as solvent from components forming the resin composition.

Moreover, the resin composition for laser engraving of the present invention preferably does not comprise a solvent, and when forming a relief-forming layer in the flexographic printing plate precursor it is preferable to form a relief-forming layer by thermal molding such as a melt extrusion method, a rubber extrusion method, or a hot pressing method without using a solvent.

As a result of an intensive investigation by the present inventors, it has been found that due to the resin composition for laser engraving comprising Component A to Component D, a resin composition for laser engraving can be provided that can give a flexographic printing plate having excellent printing durability and that is excellent in terms of film surface state, engraving sensitivity, and rinsing properties for engraving residue generated when laser engraving.

Although the detailed mechanism is unclear, it is surmised by the present inventors that by adding the specific hollow crosslinked particles to the resin composition the film density of a film that is formed decreases, and engraving sensitivity is thereby increased.

It is also surmised by the present inventors that the specific hollow crosslinked particles or thermal decomposition residue thereof absorbs liquid residue formed by decomposition of the binder to thus form a solid residue, which is easy to remove, thereby improving the rinsing properties.

Furthermore, it is surmised by the present inventors that due to the specific hollow crosslinked particles being present in a relief layer of a printing plate after plate making, the hollow crosslinked particles function as a filler, thus giving excellent printing durability.

In the present specification, with respect to explanation of the flexographic printing plate precursor, a non-crosslinked crosslinkable layer comprising Component A to Component D and having a flat surface as an image formation layer that is subjected to laser engraving is called a relief-forming layer, a layer that is formed by crosslinking the relief-forming layer is called a crosslinked relief-forming layer, and a layer that is formed by subjecting this to laser engraving so as to form asperities on the surface is called a relief layer.

(Component A) Hollow crosslinked particles comprising in polymer layer crosslinked polymer comprising (meth)acrylic acid ester-derived monomer unit and/or styrene-derived monomer unit

The resin composition for laser engraving of the present invention comprises (Component A) hollow crosslinked particles comprising in a polymer layer a crosslinked polymer comprising a (meth)acrylic acid ester-derived monomer unit and/or a styrene-derived monomer unit.

The specific hollow crosslinked particles used in the present invention may be those produced by a known method or may be commercially available particles.

As a process for producing specific hollow crosslinked particles, there are (a) a method in which a foaming agent is contained in polymer particles, and this foaming agent is subsequently made to foam, (b) a method in which a volatile substance such as butane is sealed in a polymer, and this volatile substance is subsequently gasified and swollen, (c) a method in which a polymer is melted, a jet of gas such as air is blown thereinto, and bubbles are sealed therein, (d) a method in which an alkali swelling substance is made to permeate into polymer particles, and the alkali swelling substance is made to swell, (e) a method in which a w/o/w monomer emulsion is formed and subjected to polymerization, (f) a method in which a monomer is polymerized in a suspension solution in which a pigment has been suspended in a solution of an unsaturated polyester, and (g) a two-stage crosslinking method in which crosslinked polymer particles are used as seeds, and polymers having different compatibilities are polymerized and crosslinked on the seeds.

The specific hollow crosslinked particles used in the present invention comprise in a polymer layer a crosslinked polymer comprising a (meth)acrylic acid ester-derived monomer unit and/or a styrene-derived monomer unit.

The polymer layer of the specific hollow crosslinked particles means a layer of a polymer forming an outer shell of the hollow crosslinked particles, the layer containing at least one cavity in the interior.

In the present invention, due to the polymer layer of the specific hollow crosslinked particles containing a crosslinked polymer, the hollow state of the particles is maintained even under high temperature such as that of kneading or crosslinking.

The (meth)acrylic acid ester includes a polyvalent (meth)acrylic acid ester compound and a monovalent (meth)acrylic acid ester compound.

Examples of the polyvalent (meth)acrylic acid ester compound include a diacrylate compound such as polyethylene glycol diacrylate, 1,3-butylene glycol diacrylate, 1,6-hexane glycol diacrylate, neopentyl glycol diacrylate, polypropylene glycol diacrylate, 2,2'-bis(4-acryloxypropyloxyphenyl)propane, or 2,2'-bis(4-acryloxydiethoxyphenyl)propane; a triacrylate compound such as trimethylolpropane triacrylate, trimethylolethane triacrylate, or tetramethylolmethane triacrylate; a tetraacrylate compound such as tetramethylolmethane tetraacrylate; a dimethacrylate compound such as ethylene glycol dimethacrylate, diethylene glycol dimethacrylate, triethylene glycol dimethacrylate, polyethylene glycol dimethacrylate, 1,3-butylene glycol dimethacrylate, 1,4-butylene glycol dimethacrylate, 1,6-hexane glycol dimethacrylate, neopentyl glycol dimethacrylate, dipropylene glycol dimethacrylate, polypropylene glycol dimethacrylate, or 2,2'-bis(4-methacryloxydiethoxyphenyl)propane; and a trimethacrylate compound such as trimethylolpropane trimethacrylate or trimethylolethane trimethacrylate. Among them, ethylene glycol dimethacrylate, polyethylene glycol dimethacrylate, and trimethylolpropane trimethacrylate are preferable, and ethylene glycol dimethacrylate is more preferable.

With regard to these compounds, one type may be used on its own or two or more types may be used in combination.

Examples of the monovalent (meth)acrylic acid ester compound include methyl (meth)acrylate, ethyl (meth)acrylate, *n*-propyl (meth)acrylate, isopropyl (meth)acrylate, *n*-butyl (meth)acrylate, isobutyl (meth)acrylate, *t*-butyl (meth)acrylate, amyl (meth)acrylate, *n*-hexyl (meth)acrylate, cyclohexyl (meth)acrylate, *t*-butyl cyclohexyl (meth)acrylate, 2-ethylhexyl (meth)acrylate, *t*-octyl (meth)acrylate, dodecyl (meth)acrylate, octadecyl (meth)acrylate, acetoxyethyl (meth)acrylate, phenyl (meth)acrylate, 2-hydroxyethyl (meth)acrylate, 2-hydroxypropyl (meth)acrylate, 3-hydroxypropyl (meth)acrylate, 4-hydroxybutyl (meth)acrylate, 2-methoxyethyl (meth)acrylate, 2-ethoxyethyl (meth)acrylate, 2-(2-methoxyethoxy)ethyl (meth)acrylate, 3-phenoxy-2-hydroxypropyl (meth)acrylate, 2-chloroethyl (meth)acrylate, glycidyl (meth)acrylate, 3,4-epoxycyclohexylmethyl (meth)acrylate, vinyl (meth)acrylate, 2-phenylvinyl (meth)acrylate, 1-propenyl (meth)acrylate, allyl (meth)acrylate, 2-allyloxyethyl (meth)acrylate, propargyl (meth)acrylate, benzyl (meth)acrylate, diethylene glycol monomethyl ether (meth)acrylate, diethylene glycol monoethyl ether (meth)acrylate, triethylene glycol monomethyl ether (meth)acrylate, triethylene glycol monoethyl ether (meth)acrylate, polyethylene glycol monomethyl ether (meth)acrylate, polyethylene glycol monoethyl ether (meth)acrylate, β-phenoxyethoxyethyl (meth)acrylate, nonylphenoxy polyethylene glycol (meth)acrylate, dicyclopentenyl (meth)acrylate, dicyclopentenyloxyethyl (meth)acrylate, trifluoroethyl (meth)acrylate, octafluoropentyl (meth)acrylate, perfluorooctylethyl (meth)acrylate, dicyclopentanyl (meth)acrylate, tribromophenyl (meth)acrylate, tribromophenyloxyethyl (meth)acrylate, and γ-butyrolacton-2-yl (meth)acrylate. Among them, methyl methacrylate, ethyl methacrylate, *n*-propyl methacrylate, isopropyl methacrylate, n-butyl methacrylate, isobutyl methacrylate, and *t*-butyl methacrylate are preferable, and methyl methacrylate is more preferable.

With regard to these compounds, one type may be used on its own or two or more types may be used in combination.

Examples of styrenes include styrene, methylstyrene, dimethylstyrene, trimethylstyrene, ethylstyrene, isopropylstyrene, butylstyrene, hydroxystyrene, methoxystyrene, butoxystyrene, acetoxystyrene, chlorostyrene, dichlorostyrene, bromostyrene, chloromethylstyrene, hydroxystyrene protected by a group capable of being deprotected by an acidic material (such as a *t*-Boc group (*t*-butoxycarbonyl group)), methyl vinylbenzoate, α-methylstyrene, divinylbenzene etc. Furthermore, one type thereof may be used on its own or two more types may be used in combination.

In the present invention, a first preferred embodiment of the crosslinked polymer comprising a (meth)acrylic acid ester-derived monomer unit and/or a styrene-derived monomer unit is a copolymer of divinylbenzene and a (meth)acrylic acid ester compound.

The copolymer is preferably a copolymer of divinylbenzene and a polyvalent (meth)acrylic acid ester compound, and more preferably a copolymer of divinylbenzene and a polyvalent (meth)acrylic acid ester compound and monovalent (meth)acrylic acid ester compound. Furthermore, in all the above embodiments, it is more preferable to use a methacrylic acid ester compound than an acrylic acid ester compound.

Furthermore, the copolymer preferably contains a styrene other than divinylbenzene.

Moreover, the content of divinylbenzene in the copolymer is preferably at least 10 mass%, more preferably at least 20 mass%, and yet more preferably at least 25 mass%.

A second preferred embodiment of the crosslinked polymer comprising a (meth)acrylic acid ester-derived monomer unit and/or a styrene-derived monomer unit as Component A is a copolymer of a polyvalent (meth)acrylic acid ester compound and a monovalent (meth)acrylic acid ester compound.

The copolymer is preferably a copolymer of a polyvalent methacrylic acid ester compound and a monovalent methacrylic acid ester compound.

It is preferable for the crosslinked polymer to comprise a monomer unit derived from a (meth)acrylic acid ester having a Tg of at least 80°C or a styrene having a Tg of at least 80°C. It is also preferable for it to comprise a compound having a Tg of at least 80°C as a monomer unit in an amount of at least 30 mass% in the crosslinked polymer, more preferably 40 to 95 mass%, and yet more preferably 55 to 90 mass%.

Due to a compound having a Tg of at least 80°C being contained as a monomer unit, a lithographic printing plate precursor having an excellent film surface state can be obtained.

The content of Component A is preferably 3 to 60 mass% relative to the total mass of the solids content of the resin composition for laser engraving, more preferably 15 to 60 mass%, yet more preferably 15 to 40 mass%, and particularly preferably 15 to 30 mass%.

When Component A has a content within this range, a balance can be achieved between printing durability and engraving sensitivity.

The volume-average particle size of primary particles of the hollow crosslinked particles used in the present invention is preferably 0.01 to 50 $\mu$m, more preferably 0.05 to 35 $\mu$m, and yet more preferably 0.1 to 25 $\mu$m.

When the particle size is within this range, a good balance can be achieved between engraved shape, print image quality, and ease of weighing.

Furthermore, the primary particles referred to here mean single particles that have not aggregated, and the shape thereof may be spherical, spheroidal, or an abnormal shape formed by deformation of a sphere or a spheroid.

The volume-average particle size of a particle is measured by a laser diffraction/scattering particle size distribution analyzer on a volumetric basis.

As Component A in the present invention, it is preferable to use a commercially available product. Specific examples include MHB-R and M-600 (both manufactured by Matsumoto Yushi Seiyaku Co., Ltd.) and SX866 (A), SX868 (B), SX8782 (A), and SX8782 (P) (all manufactured by JSR).

Among them, it is preferable to use MHB-R, SX866 (A), or SX8782 (P).

(Component B) Binder polymer

The resin composition for laser engraving of the present invention comprises (Component B) a binder polymer.

Component B is preferably a polymer having an ethylenically unsaturated group, more preferably a polymer having a conjugated diene-based hydrocarbon-derived monomer unit, and yet more preferably a polymer having a butadiene- and/or isoprene-derived monomer unit.

Component B is preferably a water-insoluble polymer.

Component B preferably comprises an ethylenically unsaturated bond in at least one part selected from the group consisting of a main chain interior, a main chain terminal, and a side chain, more preferably comprises an ethylenically unsaturated bond in at least one part selected from a main chain interior and a main chain terminal, and yet more preferably comprises an ethylenically unsaturated bond in at least one part of a main chain interior.

In the present invention, a 'main chain' means the relatively longest bonded chain in the molecule of a polymer compound forming a resin, a 'side chain' means a carbon chain branching from the main chain, and the side chain may comprise a heteroatom.

The ethylenically unsaturated group that Component B may comprise is not particularly limited, but is preferably a butadiene- or isoprene-derived ethylenically unsaturated bond or a (meth)acrylic group, more preferably a butadiene- or isoprene-derived ethylenically unsaturated bond or a (meth)acryloxy group, and yet more preferably a butadiene- or isoprene-derived ethylenically unsaturated bond.

Furthermore, the butadiene- or isoprene-derived ethylenically unsaturated bond may be an ethylenically unsaturated bond in the interior of a main chain formed by 1,4-addition, an ethylenically unsaturated bond of a side chain formed by 1,2-addition- or 3,4-addition, or an ethylenically unsaturated compound that is a positional isomer of the above ethylenically unsaturated bond; Component B preferably comprises at least an ethylenically unsaturated bond in the interior of a main chain formed by 1,4-addition of butadiene or isoprene.

Component B is preferably a polymer selected from the group consisting of polybutadiene, polyisoprene, a copolymer formed by copolymerization of at least butadiene and/or isoprene, and urethane (meth)acrylate, more preferably a polymer selected from the group consisting of polybutadiene, polyisoprene, and a copolymer formed by copolymerization of at least butadiene and/or isoprene, yet more preferably a polymer selected from the group consisting of polybutadiene and polyisoprene, and particularly preferably polybutadiene. With this embodiment, a flexographic printing plate can be obtained that is excellent in terms of printing durability and ink transfer properties, and rinsing properties for engraving residue are excellent.

Component B is preferably a plastomer at 20°C. With this embodiment a balance can be achieved between strength and flexibility, when carrying out crosslinking flowability is excellent and crosslinking can be carried out sufficiently, printing durability and image quality of a flexographic printing plate are excellent, and rinsing properties for engraving residue are excellent.

In the present invention a 'plastomer' means a polymer having the properties of easily being made to flow and deform by heating and being capable of solidifying into a deformed shape by cooling, as described in 'New Polymer Dictionary' edited by the Society of Polymer Science, Japan (published in 1988, Asakura Shoten, Japan). A plastomer is the opposite of an elastomer (having the properties of instantaneously deforming in response to an external force when it is applied and of recovering its original shape in a short time when the external force is removed), and is one that does not exhibit elastic deformation as in an elastomer and that easily undergoes plastic deformation.

In the present invention, the plastomer means one that, when the original size is defined as 100%, can be deformed up to 200% at room temperature (20°C) by a small external force and that does not return to a size of 130% or less when the external force is removed. The small external force specifically means an external force having a tensile strength of 1 to 100 MPa. More specifically, the plastomer here means a polymer that can be stretched, without being broken, twice the distance between reference lines of a test piece having a No. 4 dumbbell shape in accordance with JIS K 6251-1993 in a tensile test at 20°C based on a tensile set test in accordance with JIS K 6262-1997, and that exhibits a tensile set of at least 30% 5 minutes after removing the external tensile force after being held for 60 minutes in the stretched state with a distance twice the distance between the reference lines prior to stretching. In the present invention, all of the procedures were in accordance with the tensile set test method of JIS K 6262-1997 except that the test piece had a dumbbell shape defined by JIS K 6251, the holding time was 60 minutes, and the temperature of the test chamber was 20°C.

A polymer that cannot be measured as above, that is, a polymer that deforms without applying an external tensile force in the tensile test and does not return to its original shape or a polymer that breaks when a small external force is applied during measurement, corresponds to a plastomer. For example, a polymer that is a liquid at 20°C is a plastomer.

Furthermore, a polymer may be determined as being a plastomer from the glass transition temperature (Tg) of the polymer being less than 20°C. In the case of a polymer having two or more Tgs, all of the Tgs are less than 20°C. The Tg of a polymer may be measured by a differential scanning calorimetry (DSC) method.

The polybutadiene structure-containing polymer or the polyisoprene structure-containing polymer may be a homopolymer of butadiene or isoprene, a copolymer formed by copolymerization of butadiene and/or isoprene, or a polymer formed by modifying the above.

Furthermore, the polybutadiene structure-containing polymer or the polyisoprene structure-containing polymer may be a polymer comprising mainly an isoprene or butadiene monomer unit in the main chain, and part thereof may be hydrogenated and converted into a saturated bond. Moreover, the main chain or a terminal of the polymer may be modified with an amide, a carboxy group, a hydroxy group, a (meth)acryloyl group, etc., or may be epoxidized.

Examples of copolymerizable monomers include, but are not particularly limited to, styrene, $\alpha$-methylstyrene, o-methylstyrene, p-methylstyrene, acrylonitrile, methacrylonitrile, vinyl chloride, vinylidene chloride, acrylamide, methacrylamide, vinyl methacrylamidoacetate, an acrylic acid ester, a methacrylic acid ester, acrylic acid, and methacrylic acid.

Specific examples of the copolymer formed by copolymerization of at least butadiene and/or isoprene include a styrene-butadiene copolymer, a styrene-isoprene polymer, an acrylonitrile-butadiene copolymer, an acrylonitrile-isoprene copolymer, an acrylic acid ester-butadiene copolymer, an acrylic acid ester-isoprene copolymer, an acrylic acid ester-chloroprene copolymer, an acrylonitrile-butadiene-styrene copolymer, a styrene-isoprene-styrene block copolymer, a styrene-butadiene-styrene block copolymer, a terminal (meth)acrylate-modified polybutadiene, a terminal (meth)acrylate-modified polyisoprene, a terminal (meth)acrylate-modified hydrogenated polybutadiene, and a terminal (meth)acrylate-modified hydrogenated polyisoprene.

The polybutadiene structure-containing polymer and the polyisoprene structure-containing polymer may be produced by emulsion polymerization or solution polymerization.

In the present invention, the polybutadiene structure-containing polymer and the polyisoprene structure-containing polymer preferably have a proportion of aliphatic hydrocarbon (isoprene, butadiene, or hydrogenated derivative thereof)-derived monomer unit in the main chain of at least 80 mol%. It is preferable for the proportion of aliphatic hydrocarbon-derived monomer unit in the main chain to be at least 80 mol% since the rinsing properties are good. The aliphatic hydrocarbon-derived monomer unit content is more preferably at least 90 mol% of the total monomer units forming the main chain of Component B, yet more preferably at least 95 mol%, and particularly preferably at least 99 mol%.

That is, for example, the proportion in total of isoprene- and hydrogenated isoprene derivative-derived monomer units of the polyisoprene structure-containing polymer is preferably at least 80 mol%, more preferably at least 90 mol%, yet more preferably at least 95 mol%, and particularly preferably at least 99 mol%.

Similarly, the proportion in total of butadiene- and hydrogenated butadiene derivative-derived monomer units in the polybutadiene structure-containing polymer is preferably at least 80 mol%, more preferably at least 90 mol%, yet more preferably at least 95 mol%, and particularly preferably at least 99 mol%.

When an isoprene or butadiene copolymer is used as Component B, it preferably comprises isoprene-, butadiene-, and their hydrogenated derivative-derived monomer units in a total amount of at least 80 mol%, more preferably at least 90 mol%, yet more preferably at least 95 mol%, and particularly preferably at least 99 mol%.

It is known that isoprene can be made to undergo polymerization via 1,2-, 3,4-, or 1,4-addition by means of a catalyst or reaction conditions, and the present invention may employ polyisoprene that has been polymerized by any of the above addition modes. Among them, from the viewpoint of obtaining a desired Mooney viscosity, it is preferable for cis-1,4-polyisoprene to be contained as a main component. The content of cis-1,4-polyisoprene is preferably at least 50 mass%, more preferably at least 65 mass%, yet more preferably at least 80 mass%, and particularly preferably at least 90 mass%.

Furthermore, as the polyisoprene a commercial polyisoprene may be used, and examples include the NIPOL IR series (Nippon Zeon Corporation).

It is known that butadiene is polymerized by 1,2- or 1,4-additionon depending on a catalyst or reaction conditions, and in the present invention, polybutadiene polymerized by any of these additions may be used. Among these, from the viewpoint of obtaining a desired Mooney viscosity, 1,4-butadiene is more preferable as a main component.

The content of 1,4-polybutadiene is preferably 50 mass % or greater, more preferably 65 mass % or greater, even more preferably 80 mass % or greater, and particularly preferably 90 mass % or greater.

Moreover, the content of cis isomer and trans isomer is not particularly limited, and may be selected so as to obtain a desired the viscosity and the Mooney viscosity, however, from the viewpoint of exhibiting rubber elasticity, cis product is preferable. The content of cis-1,4-polybutadiene is preferably 50 mass % or greater, more preferably 65 mass % or greater, even more preferably 80 mass % or greater, and particularly preferably 90 mass % or greater.

As the polybutadiene, commercially available products may be used, and examples thereof include NIPOL (registered trademark) BR series (manufactured by ZEON CORPORATION) and UBEPOL (registered trademark) BR series (manufactured by UBE INDUSTRIES, LTD.).

As liquid polybutadiene, commercially available products such as Kuraprene LBR-305 (Kuraray Co., Ltd.) and Ricon (Sartomer) can be cited as examples.

Examples of liquid polyisoprene include Kuraprene LIR-30 and LIR-50 (Kuraray Co., Ltd.).

Examples of a (meth)acrylate group-containing polyisoprene include a polyisoprene into which methacrylate has been introduced (Kuraprene UC-203 and UC-102, Kuraray Co., Ltd.).

Examples of a terminal ethylenically unsaturated group-containing polybutadiene include a polybutadiene into which a (meth)acrylate group has been introduced (NISSO-PB TEAI-1000 and EA-3000, Nippon Soda Co., Ltd.).

Among them, the polybutadiene structure-containing polymer and the polyisoprene structure-containing polymer are more preferably polyisoprene, polybutadiene, a styrene-isoprene-styrene block copolymer, or a styrene-butadiene-styrene block copolymer, and particularly preferably polyisoprene or polybutadiene.

From the viewpoint of printing durability of a flexographic printing plate, rinsing properties for engraving residue, and ease of handling, Component B is preferably polybutadiene or polyisoprene, and particularly preferably polybutadiene.

The urethane (meth)acrylate is a polyurethane resin comprising a (meth)acryloxy group in a main chain interior, a main chain terminal, or a side chain; examples include an aliphatic urethane (meth)acrylate and an aromatic urethane (meth)acrylate. Details may be referred to in the Oligomer Handbook (Ed. by Junji Furukawa, The Chemical Daily Co., Ltd.).

The urethane (meth)acrylate preferably comprises in the molecule at least one type of bond selected from a carbonate bond and an ester bond. Due to the urethane (meth)acrylate comprising the above bond, resistance of a printing plate toward an ink washing liquid containing an ester-based solvent or an ink washing liquid containing a hydrocarbon-based solvent used in printing is improved.

Examples of carbonate bond-containing diol compounds used in the production of a hydroxy group-containing polyurethane resin include an aliphatic polycarbonate diol such as a 4,6-polyalkylene carbonate diol, an 8,9-polyalkylene carbonate diol, or a 5,6-polyalkylene carbonate diol. Furthermore, an aromatic ring-containing polycarbonate diol may also be used.

A urethane bond may be introduced by a condensation reaction between a terminal hydroxy group of these compounds and a polyisocyanate compound such as a diisocyanate compound like tolylene diisocyanate, diphenylmethane diisocyanate, hexamethylene diisocyanate, isophorone diisocyanate, dicyclohexylmethane diisocyanate, tetramethylxylene diisocyanate, xylene diisocyanate, naphthalene diisocyanate, trimethylhexamethylene diisocyanate, p-phenylene diisocyanate, cyclohexylene diisocyanate, lysine diisocyanate, or triphenylmethane diisocyanate, or a triisocyanate compound such as triphenylmethane triisocyanate, 1-methylbenzene-2,4,6-triisocyanate, naphthalene-1,3,7-triisocyanate, or biphenyl-2,4,4'-triisocyanate.

The urethane (meth)acrylate may be obtained as a commercial product such as for example UV-3200, UV-3000B, UV-3700B, UV-3210EA, UV-2000B, or UV-3630ID80 of the Shikoh series (all from The Nippon Synthetic Chemical Industry Co., Ltd.), EBECRYL 230 or EBECRYL 9227EA (both from Daicel-Cytec Company Ltd.), or AU-3040, AU-3050, AU-3090, AU-3110, or AU-3120 of the Hi-Coap AU series (all from TOKUSHIKI Co., Ltd.).

As an alternative method for obtaining a urethane (meth)acrylate, etc., there is a method in which a polyurethane is formed by a polyaddition reaction between the above polyisocyanate compound and a (meth)acryloxy group-containing diol compound.

Preferred examples of the (meth)acryloxy group-containing diol compound used in this case include Blemmer GLM manufactured by NOF Corporation, and DA-212, DA-250, DA-721, DA-722, DA-911M, DA-920, DA-931, DM-201, DM-811, DM-832, and DM-851 of the 'Denacol acrylate' series manufactured by Nagase ChemteX Corporation.

Furthermore, as Component B an ethylene-propylene-diene copolymer can also be cited as a preferred example. The copolymer is more preferably an ethylene-propylene-5-ethylidene-2-norbornene copolymer.

The molecular weight of Component B, as a weight-average molecular weight (GPC, polystyrene basis), is preferably at least 1,000, more preferably at least 10,000, yet more preferably at least 100,000, and particularly preferably at least 500,000. The molecular weight of Component B, as a weight-average molecular weight (GPC, polystyrene basis), is preferably no greater than 3,000,000, more preferably no greater than 2,000,000, and yet more preferably no greater than 1,500,000. When in this range, it is easy to process a resin composition for laser engraving, and a resulting flexographic printing plate has excellent printing durability.

In the present invention, weight-average molecular weight and number-average molecular weight may be measured by a gel permeation chromatographic (GPC) method, and determined by conversion using a reference polystyrene. Specifically, for example, an HLC-8220 GPC (Tosoh Corporation) is used as the GPC with three columns, that is, TSKgeL SuperHZM-H, TSKgeL SuperHZ4000, and TSKgeL SuperHZ2000 (Tosoh Corporation, 4.6 mm ID × 15 cm) as columns, and THF (tetrahydrofuran) as eluent. The conditions are such that the sample concentration is 0.35 mass%, the flow rate is 0.35 mL/min, the amount of sample injected is 10 μL, the measurement temperature is 40°C, and an IR detector is used. Furthermore, a calibration curve is generated from eight samples of 'reference sample TSK standard, polystyrene', that is, 'F-40', 'F-20', 'F-4', 'F-1', 'A-5000', 'A-2500', 'A-1000', and 'n-propylbenzene' manufactured by Tosoh Corporation.

In the present invention, the Mooney viscosity of Component B is not particularly limited, but is preferably no greater than 90 from the viewpoint of solvent solubility and ease of handling when mixing, more preferably no greater than 70, and yet more preferably no greater than 60. Furthermore, the lower limit value of the Mooney viscosity is not particularly limited, and Component B may be in for example a liquid, syrup, etc. state.

In the present invention, the Mooney viscosity is a value measured in accordance with JIS6300-1. Specifically, a cylindrical space is formed between temperature-controllable dies as a sample chamber, a rotor is disposed in a central part of the sample chamber, the sample chamber is charged with a sample to be measured, in a state in which the temperature thereof is maintained at a predetermined temperature the rotor is rotated at a defined rotational speed, and the counter-torque of the rotor caused by viscous resistance of the molten sample is detected using a load cell. In addition, the value for Mooney viscosity used in the present invention is obtained using an L type rotor for a preheating time of 1 minute and a rotor rotational time of 4 minutes, and the Mooney viscosity of a rubber sample is the Mooney viscosity ($ML_{1+4}$) measured after preheating at 100°C for 1 minute and rotating the rotor for 4 minutes.

The content of Component B is preferably 50 to 95 mass% relative to the total mass of the solids content of the resin composition for laser engraving, more preferably 55 to 90 mass%, yet more preferably 60 to 90 mass%, and particularly preferably 60 to 85 mass%. When the content of Component B is in this range, a relief layer that is excellent in terms of rinsing properties for engraving residue and ink transfer properties is obtained.

The resin composition for laser engraving of the present invention may comprise a polymer other than Component B, that is, a polymer that does not comprise an ethylenically unsaturated bond. Examples of the polymer other than Component B include non-elastomers described in JP-A-2011-136455, unsaturated group-containing polymers described in JP-A-2010-208326, and binder polymers described in paragraphs 0009 to 0030 of JP-A-2012-45801.

Other examples include hydrogenated polybutadiene or hydrogenated polyisoprene.

When the resin composition for laser engraving of the present invention comprises a polymer other than Component B, it is preferably no greater than 30 mass% relative to the total mass of the solids content of the resin composition for laser engraving, more preferably no greater than 10 mass%, yet more preferably no greater than 5 mass%, particularly preferably no greater than 2 mass%, and most preferably 0 mass%, that is, none being contained. When in this range, a relief layer that is excellent in terms of rinsing properties for engraving residue and ink transfer properties is obtained.


(Component C) Peroxide

The resin composition for laser engraving of the present invention comprises (Component C) a peroxide.

Since a peroxide has high reactivity, not only is it possible to carry out polymerization of an ethylenically unsaturated group, but it is also possible to abstract a hydrogen atom bonded to a saturated carbon atom of a saturated hydrocarbon chain to thus generate a carbon radical and form carbon atom-carbon atom crosslinking.

Examples of the peroxide include an inorganic peroxide and an an organic peroxide but an organic peroxide is preferably used.

The organic peroxide is preferably a dialkyl peroxide, a peroxyketal, a peroxyester, a diacyl peroxide, an alkyl hydroperoxide, a peroxydicarbonate, or a ketone peroxide, and more preferably an organic peroxide selected from the group consisting of a dialkyl peroxide, a peroxyketal, and a peroxyester.

Examples of the dialkyl peroxide include di-t-butyl peroxide, di-t-hexyl peroxide, t-butylcumyl peroxide, dicumyl peroxide, α,α'-bis(t-butylperoxy)diisopropylbenzene, 2,5-dimethyl-2,5-bis(t-butylperoxy)hexane, and 2,5-dimethyl-2,5-bis(t-butylperoxy)hexyne-3.

Examples of the peroxyketal include n-butyl 4,4-bis(t-butylperoxy)valerate, 2,2-bis(t-butylperoxy)butane, 1,1-bis(t-butylperoxy)cyclohexane, 1,1-bis(t-hexylperoxy)cyclohexane, 1,1-bis(t-butylperoxy)-3,3,5-trimethylcyclohexane, and 1,1-bis(*t*-hexylperoxy)-3,3,5-trimethylcyclohexane.

Examples of the peroxy ester include α-cumyl peroxyneodecanoate, 1,1-dimethyl-3-hydroxybutyl peroxy-2-ethylhexanoate, *t*-amyl peroxybenzoate, *t*-butyl peroxypivalate, 3,3',4,4'-tetra(*t*-butyl peroxycarbonyl)benzophenone, 3,3',4,4'-tetra(*t*-amyl peroxycarbonyl)benzophenone, 3,3',4,4'-tetra(*t*-hexyl peroxycarbonyl)benzophenone, 3,3',4,4'-tetra(*t*-octyl peroxycarbonyl)benzophenone, 3,3',4,4'-tetra(cumyl peroxycarbonyl)benzophenone, 3,3',4,4'-tetra(*p*-isopropylcumyl peroxycarbonyl)benzophenone, di-*t*-butyl diperoxyisophthalate, di-*t*-butyl diperoxyisophthalate, *t*-butyl peroxybenzoate, *t*-butyl peroxy-3-methylbenzoate, *t*-butyl peroxylaurate, *t*-butyl peroxypivalate, *t*-butyl peroxy-2-ethylhexanoate, *t*-butyl peroxy-3,5,5-trimethylhexanoate, *t*-butyl peroxyneoheptanoate, *t*-butyl peroxyneodecanoate, *t*-butyl peroxyacetate, α,α'-di(*t*-butyl peroxy)diisopropylbenzene, *t*-butylcumyl peroxide, di-*t*-butyl peroxide, *t*-butyl peroxyisopropylmonocarbonate, and *t*-butyl peroxy-2-ethylhexylmonocarbonate.

Furthermore, examples of organic peroxides that can be used include a diacyl peroxide such as dibenzoyl peroxide, succinic acid peroxide, dilauroyl peroxide, or didecanoyl peroxide, an alkyl hydroperoxide such as 2,5-dihydroperoxy-2,5-dimethylhexane, cumene hydroperoxide, or *t*-butyl hydroperoxide, and a peroxydicarbonate such as di(*n*-propyl) peroxydicarbonate, di(*sec*-butyl) peroxydicarbonate, or di(2-ethylhexyl) peroxydicarbonate.

Among them, dicumyl peroxide is particularly preferable.

Organic peroxides are commercially available, and commercial products are available from for example NOF Corporation, Kayaku Akzo Corporation, etc.

Furthermore, as an inorganic peroxide may be used, and specific examples thereof include calcium peroxide, magnesium peroxide, strontium peroxide, barium peroxide, lithium peroxide, sodium peroxide, potassium peroxide, zinc peroxide, silver peroxide, copper peroxide, iron peroxide, and lead peroxide. Among them, calcium peroxide, barium peroxide, sodium peroxide, and zinc peroxide are preferable, and calcium peroxide and zinc peroxide are particularly preferable.

Although the detailed mechanism is not clear, when carrying out laser engraving, induced degradation of peroxide occurs on the carbon black surface. Because of this, there are more initiator radicals on the carbon black surface than in a region away from the carbon black surface, and more covalent bonds (C-C single bonds) between carbon black and an ethylenically unsaturated bond of a binder are formed. It is surmised that, as a result, melting of a pattern during laser engraving is suppressed to a greater extent, and a sharp engraved shape that is true to the beam profile of the laser is obtained. The sharper the engraved shape, the better the sharpness (the higher the resolution) of print image quality.

In the present invention, with regard to Component C, one type may be used on its own or two or more types may be used in combination.

The content of Component C contained in the resin composition for laser engraving of the present invention is preferably at least 0.01 mass% relative to the total mass of the solids content of the resin composition, more preferably at least 0.1 mass%, and yet more preferably at least 0.5 mass%. Furthermore, although the upper limit for the content of Component C is not particularly limited, from the viewpoint of the amounts of other components added, it is preferably no greater than 30 mass%, more preferably no greater than 20 mass%, and yet more preferably no greater than 10 mass%. When the content is in this range, a flexographic printing plate that is better in terms of printing durability and ink transfer properties is obtained, and rinsing properties for engraving residue are better.

(Component D) Photothermal conversion agent

The resin composition for laser engraving of the present invention comprises a photothermal conversion agent.

It is surmised that the photothermal conversion agent absorbs laser light and generates heat thus promoting thermal decomposition of a cured material of the resin composition for laser engraving of the present invention. Because of this, it is preferable to select a photothermal conversion agent that absorbs light having the wavelength of the laser that is used for engraving.

When a laser (a YAG laser, a semiconductor laser, a fiber laser, a surface emitting laser, etc.) emitting infrared at a wavelength of 700 nm to 1,300 nm is used as a light source for laser engraving, it is preferable for the relief-forming layer in the present invention to comprise a photothermal conversion agent that can absorb light having a wavelength of 700 nm to 1,300 nm.

As the photothermal conversion agent in the present invention, various types of dye or pigment are used.

With regard to the photothermal conversion agent, examples of dyes that can be used include commercial dyes and known dyes described in publications such as 'Senryo Binran' (Dye Handbook) (Ed. by The Society of Synthetic Organic Chemistry, Japan, 1970). Specific examples include dyes having a maximum absorption wavelength at 700 nm to 1,300 nm, such as azo dyes, metal complex salt azo dyes, pyrazolone azo dyes, naphthoquinone dyes, anthraquinone dyes, phthalocyanine dyes, carbonium dyes, diimmonium compounds, quinone imine dyes, methine dyes, cyanine dyes, squarylium colorants, pyrylium salts, and metal thiolate complexes. In particular, cyanine-based colorants such as heptamethine cyanine colorants, oxonol-based colorants such as pentamethine oxonol colorants, and phthalocyanine-based colorants are preferably used. Examples include dyes described in paragraphs 0124 to 0137 of JP-A-2008-63554.

With regard to the photothermal conversion agent used in the present invention, examples of pigments include commercial pigments and pigments described in the Color Index (C.I.) Handbook, 'Saishin Ganryo Binran' (Latest Pigments Handbook) (Ed. by Nippon Ganryo Gijutsu Kyokai, 1977), 'Saisin Ganryo Ouyogijutsu' (Latest Applications of Pigment Technology) (CMC Publishing, 1986), 'Insatsu Inki Gijutsu' (Printing Ink Technology) (CMC Publishing, 1984). Examples include pigments described in paragraphs 0122 to 0125 in JP-A-2009-178869. Among these pigments, carbon black is preferable.

Any carbon black, regardless of classification by ASTM (American Society for Testing and Materials) and application (e.g. for coloring, for rubber, for dry cell, etc.), may be used as long as dispersibility, etc. in the composition is stable. Carbon black includes for example furnace black, thermal black, channel black, lamp black, and acetylene black. In order to make dispersion easy, a black colorant such as carbon black may be used as color chips or a color paste by dispersing it in nitrocellulose or a binder in advance using, as necessary, a dispersant, and such chips and paste are readily available as commercial products. Examples include carbon black include described in paragraphs 0130 to 0134 in JP-A-2009-178869.

In the present invention, with regard to Component D, one type may be used on its own or two or more types may be used in combination.

The content of the photothermal conversion agent in the resin composition for laser engraving of the present invention largely depends on the size of the molecular extinction coefficient characteristic to the molecule, and is preferably 0.01 to 30 wt % relative to the total weight of the solids content of the resin composition, more preferably 0.05 to 20 wt %, and yet more preferably 0.1 to 10 wt %.

(Component E) Polymerizable compound

In order to promote formation of a crosslinked structure, the resin composition for laser engraving of the present invention preferably comprises substantially none of (Component E) a polymerizable compound. Comprising substantially none means comprising none at all or the content being less than 2 mass%.

Furthermore, Component E is a polymerizable compound other than Component B.

Moreover, Component E is preferably a compound having a molecular weight of less than 3,000, more preferably a compound having a molecular weight of less than 2,000, and yet more preferably a compound having a molecular weight of less than 1,000.

Component E is preferably a radically polymerizable compound and is preferably an ethylenically unsaturated compound.

The polymerizable compound that can be used in the present invention is preferably a polyfunctional polymerizable compound, and more preferably a polyfunctional ethylenically unsaturated compound,. With this embodiment, the resin composition is excellent in terms of curability, and a flexographic printing plate having excellent printing durability is obtained.

Furthermore, the polyfunctional ethylenically unsaturated compound that can be used in the present invention preferably has a molecular weight (or weight-average molecular weight) of less than 2,000.

The polyfunctional ethylenically unsaturated compound referred to here is a compound having two or more ethylenically unsaturated groups. With regard to the polyfunctional ethylenically unsaturated compound, one type may be used on its own or two or more types may be used in combination.

Furthermore, compounds classified as ethylenically unsaturated compounds are widely known in the present industrial field, and in the present invention they can be used without particular limitations. They are in a chemical form of for example a monomer, a prepolymer, that is, a dimer, a trimer, or an oligomer, a copolymer thereof, or a mixture thereof.

As the polyfunctional ethylenically unsaturated compound, a polyfunctional monomer is preferably used. The molecular weight (weight-average molecular weight when there is molecular weight distribution) of these polyfunctional monomers is preferably at least 200 but less than 2,000, more preferably 200 to 1,000, and yet more preferably 200 to 700.

As the polyfunctional monomer, a compound having 2 to 20 terminal ethylenically unsaturated groups is preferable.

Examples of the polyfunctional monomer include unsaturated carboxylic acids (such as acrylic acid, methacrylic acid, itaconic acid, crotonic acid, isocrotonic acid and maleic acid), and esters and amides thereof. Preferably esters of an unsaturated carboxylic acid and an aliphatic polyhydric alcoholic compound, or amides of an unsaturated carboxylic acid and an aliphatic polyvalent amine compound are used. Moreover, addition reaction products of unsaturated carboxylic acid esters or amides having a nucleophilic substituent such as a hydroxyl group or an amino group with polyfunctional isocyanates or epoxies, and dehydrating condensation reaction products with a polyfunctional carboxylic acid, etc. are also used favorably. Moreover, addition reaction products of unsaturated carboxylic acid esters or amides having an electrophilic substituent such as an isocyanato group or an epoxy group with monofunctional or polyfunctional alcohols or amines, and substitution reaction products of unsaturated carboxylic acid esters or amides having a leaving group such as a halogen group or a tosyloxy group with monofunctional or polyfunctional alcohols or amines are also favorable. Moreover, as another example, the use of compounds obtained by replacing the unsaturated carboxylic acid with a vinyl compound, an allyl compound, an unsaturated phosphonic acid, styrene or the like is also possible.

The ethylenically unsaturated group which is comprised in the polyfunctional monomer described above is preferably an residue of an acrylate compound, a methacrylate compound, a vinyl compound, or an aryl compound, and particularly preferably an acrylate compound or a methacrylate compound, from the viewpoint of reactivity.

Specific examples of ester monomers comprising an ester of an aliphatic polyhydric alcohol compound and an unsaturated carboxylic acid include acrylic acid esters such as ethylene glycol diacrylate, diethylene glycol diacrylate, triethylene glycol diacrylate, polyethylene glycol diacrylate, 1,3-butanediol diacrylate, tetramethylene glycol diacrylate, propylene glycol diacrylate, dipropylene glycol diacrylate, tripropylene glycol diacrylate, polypropylene glycol diacrylate, neopentyl glycol diacrylate, 1,6-hexanediol diacrylate, 1,4-cyclohexanediol diacrylate, tetraethylene glycol diacrylate, polytetramethylene glycol diacrylate, 1,8-octanediol diacrylate, 1,9-nonanediol diacrylate, 1,10-decanediol diacrylate, tricyclodecane dimethanol diacrylate, trimethylolpropane triacrylate, trimethylolpropane tri(acryloyloxypropyl) ether, ditrimethyrolpropane tetraacrylate, trimethylolethane triacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, and a polyester acrylate oligomer.

Examples of methacrylic acid esters include tetramethylene glycol dimethacrylate, ethylene glycol dimethacrylate, diethylene glycol dimethacrylate, triethylene glycol dimethacrylate, polyethylene glycol dimethacrylate, propylene glycol dimethacrylate, dipropylene glycol dimethacrylate, tripropylene glycol dimethacrylate, polypropylene glycol dimethacrylate, neopentyl glycol dimethacrylate, trimethylolpropane trimethacrylate, trimethylolethane trimethacrylate, 1,3-butanediol dimethacrylate, 1,6-hexanediol dimethacrylate, 1,8-octanediol dimethacrylate, 1,9-nonanediol dimethacrylate, 1,10-decanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)phenyl]dimethylmethane, and bis[p-(methacryloxyethoxy)phenyl]dimethylmethane.

As examples of other esters, aliphatic alcohol-based esters described in JP-B-46-27926 (JP-B denotes a Japanese examined patent application publication), JP-B-51-47334 and JP-A-57-196231, those having an aromatic skeleton described in JP-A-59-5240, JP-A-59-5241, and JP-A-2-226149, those having an amino group described in JP-A-1-165613, etc. may also be used preferably.

The above-mentioned ester monomers may be used as a mixture.

Furthermore, specific examples of amide monomers including an amide of an aliphatic polyamine compound and an unsaturated carboxylic acid include methylenebisacrylamide, methylenebismethacrylamide, 1,6-hexamethylenebisacrylamide, 1,6-hexamethylenebismethacrylamide, diethylenetriaminetrisacrylamide, xylylenebisacrylamide, and xylylenebismethacrylamide.

Preferred examples of other amide-based monomers include those having a cyclohexylene structure described in JP-B-54-21726.

Furthermore, a urethane-based addition-polymerizable compound produced by an addition reaction of an isocyanate and a hydroxy group is also suitable, and specific examples thereof include a vinylurethane compound comprising two or more polymerizable vinyl groups per molecule in which a hydroxy group-containing vinyl monomer represented by Formula (i) below is added to a polyisocyanate compound having two or more isocyanate groups per molecule described in JP-B-48-41708.

$$CH_2=C(R)COOCH_2CH(R')OH \qquad (i)$$

wherein R and R' independently denote H or $CH_3$.

Furthermore, urethane acrylates described in JP-A-51-37193, JP-B-2-32293, and JP-B-2-16765, and urethane compounds having an ethylene oxide-based skeleton described in JP-B-58-49860, JP-B-56-17654, JP-B-62-39417, JP-B-62-39418 are also suitable.

Furthermore, by use of an addition-polymerizable compound having an amino structure in the molecule described in JP-A-63-277653, JP-A-63-260909, and JP-A-1-105238, a resin composition having very good curing speed can be obtained.

Other examples include polyester acrylates such as those described in JP-A-48-64183, JP-B-49-43191, and JP-B-52-30490, and polyfunctional acrylates and methacrylates such as epoxy acrylates formed by a reaction of an epoxy resin and (meth)acrylic acid. Examples also include specific unsaturated compounds described in JP-B-46-43946, JP-B-1-40337, and JP-B-1-40336, and vinylphosphonic acid-based compounds described in JP-A-2-25493. In some cases, perfluoroalkyl group-containing structures described in JP-A-61-22048 are suitably used. Moreover, those described as photocuring monomers or oligomers in the Journal of the Adhesion Society of Japan, Vol. 20, No. 7, pp. 300 to 308 (1984) may also be used.

Examples of monofunctional polymerizable compounds include unsaturated carboxylic acids such as acrylic acid, methacrylic acid, itaconic acid, crotonic acid, isocrotonic acid, and maleic acid and salts thereof, an ethylenically unsaturated group-containing anhydride, a (meth)acrylate, a (meth)acrylamide, an acrylonitrile, a styrene, and various types of polymerizable compounds such as an unsaturated polyester resin, an unsaturated polyether resin, an unsaturated polyamide resin, and an unsaturated urethane resin.

Further, addition products of an unsaturated carboxylic acid ester or amide having a nucleophilic substituent such as a hydroxy group, an amino group or a mercapto group with a monofunctional or polyfunctional isocyanate compound or an epoxy compound, dehydrating condensation products with a monofunctional or polyfunctional carboxylic acid, etc. are preferably used.

Moreover, as a radically polymerizable compound, addition reaction products of unsaturated carboxylic acid esters or amides having an electrophilic substituent such as an isocyanato group or an epoxy group with alcohols, amines or thiols, and substitution reaction products of unsaturated carboxylic acid esters or amides having a leaving group such as a halogen group or a tosyloxy group with alcohols, amines, or thiols are also favorable.

Moreover, as another example, the use of compounds obtained by replacing the unsaturated carboxylic acid with an unsaturated phosphonic acid, styrene, vinyl ether or the like is also possible.

As the polymerizable compound, the above examples of compound and various known compounds can be used without any particular limitation, and for example, compounds disclosed in JP-A-2009-204962 may be used.

Furthermore, as a monofunctional ethylenically unsaturated compound, a (meth)acrylate derivative such as methyl (meth)acrylate, ethyl (meth)acrylate, n-butyl (meth)acrylate, 2-ethylhexyl (meth)acrylate, 2-hydroxyethyl (meth)acrylate, butoxyethyl (meth)acrylate, carbitol (meth)acrylate, cyclohexyl (meth)acrylate, benzyl (meth)acrylate, *N*-methylol (meth)acrylamide, or epoxy (meth)acrylate, an N-vinyl compound such as *N*-vinylpyrrolidone or *N*-vinylcaprolactam, or an allyl compound derivative such as allyl glycidyl ether, diallyl phthalate, or triallyl trimellitate is preferably used.

Among them, as the monofunctional ethylenically unsaturated compound, a monofunctional (meth)acrylate compound (monofunctional (meth)acrylic acid ester) is preferable.

Among these, Component E is preferably an acrylate (acrylic acid ester compound) or a methacrylate (methacrylic acid ester compound), and particularly preferably an ester of an aliphatic polyhydric alcohol and an acrylic acid or a methacrylic acid. Component E preferably contains 2 to 20 (meth)acryloyloxy groups, more preferably 2 to 8 (meth)acryloyloxy groups, even more preferably 2 to 6 (meth)acryloyloxy groups, and particularly preferably 2 or 4 (meth)acryloyloxy groups, in one molecule.

Among these, Component E preferably comprises at least one compound selected from the group consisting of hexanediol di(meth)acrylate, decanediol di(meth)acrylate, tricyclodecane dimethanol di(meth)acrylate, pentaerythritol tetra(meth)acrylate, dipentaerythritol hexa(meth)acrylate.

When the resin composition comprises Component E, the content of Component E in the resin composition for laser engraving is preferably 1 to 50 mass% relative to the total solids content, more preferably 3 to 40 mass%, and yet more preferably 5 to 30 mass%. When in the above-mentioned range, a relief-forming layer comprising the resin composition for laser engraving has excellent printing durability.

Furthermore, from the viewpoint of improvement of printing durability and a suppressed amount of engraving residue, the content of Component E in the resin composition for laser engraving is preferably 10 to 50 mass% relative to the total solids content.

Various types of Components contained in the resin composition for laser engraving of the present invention other than Components A to E are explained below.

<Crosslinking agent>

Furthermore, the resin composition for laser engraving of the present invention may comprise a crosslinking agent. Preferred examples of the crosslinking agent include a vulcanizing agent and a polymerization initiator. Those included in Component C are not included in the crosslinking agent.

Moreover, the polymerization initiator is preferably used in combination with Component E.

<vulcanizing agent>

The vulcanizing agent in the present invention is elemental sulfur (free sulfur) or an sulfur-donating organic vulcanizing agent can be cited, and elemental sulfur is preferable.

As the sulfur-donating organic vulcanizing agent, morpholine disulfide, dithiodicaprolactam, an alkyl phenol disulfide, a polymeric polysulfide, etc. are used.

The vulcanizing agent may be a commercially available product, and specific examples thereof include a surfer (Tsurumi Chemical, Inc.) and vulnoc R (Ouchi Sinko Chemical Industrial, morpholine disulfide).

<Polymerization initiator>

With regard to the polymerization initiator, one known to a person skilled in the art may be used without any limitations. Radical polymerization initiators, which are preferred polymerization initiators, are explained in detail below, but the present invention should not be construed as being limited to these descriptions.

In the present invention, as the polymerization initiator, a radical polymerization initiator is preferable.

The polymerization initiator may be a photopolymerization initiator or a thermopolymerization initiator, and is preferably a thermopolymerization initiator.

In the present invention, preferable polymerization initiators include (a) aromatic ketones, (b) onium salt compounds, (c) thio compounds, (d) hexaallylbiimidazole compounds, (e) ketoxime ester compounds, (f) borate compounds, (g) azinium compounds, (h) metallocene compounds, (i) active ester compounds, (j) compounds having a carbon halogen bond, and (k) azo compounds. Hereinafter, although specific examples of the (a) to (k) are cited, the present invention is not limited to these.

The (a) aromatic ketones, (b) onium salt compounds, (c) thio compounds, (d) hexaallylbiimidazole compounds, (e) ketoxime ester compounds, (f) borate compounds, (g) azinium compounds, (h) metallocene compounds, (i) active ester compounds, and (j) compounds having a carbon halogen bonding may preferably include compounds described in paragraphs 0074 to 0118 of JP-A-2008-63554.

Moreover, (k) azo compounds preferably include the following compounds.

(k) Azo compounds

Preferable (k) azo compounds as a polymerization initiator that can be used in the present invention include those such as 2,2'-azobisisobutyronitrile, 2,2'-azobispropionitrile, 1,1'-azobis(cyclohexane-1-carbonitrile), 2,2'-azobis(2-methylbutyronitrile), 2,2'-azobis(2,4-dimethylvaleronitrile), 2,2'-azobis(4-methoxy-2,4-dimethylvaleronitrile), 4,4'-azobis(4-cyanovaleric acid), dimethyl 2,2'-azobis(isobutyrate), 2,2'-azobis(2-methylpropionamideoxime), 2,2'-azobis[2-(2-imidazolin-2-yl)propane], 2,2'-azobis{2-methyl-*N*-[1,1-bis(hydroxymethyl)-2-hydroxyethyl]propionamide), 2,2'-azobis[2-methyl-N-(2-hydroxyethyl)propionamide], 2,2'-azobis(*N*-butyl-2-methylpropionamide), 2,2'-azobis(*N*-cyclohexyl-2-methylpropionamide), 2,2'-azobis[*N*-(2-propenyl)-2-methyl-propionamide], 2,2'-azobis(2,4,4-trimethylpentane).

<Solvent>

The resin composition for laser engraving of the present invention may comprise a solvent, however it is preferable not to comprise a solvent.

As a solvent, an organic solvent is preferable.

Specific preferred examples of the aprotic organic solvent include acetonitrile, tetrahydrofuran, dioxane, toluene, propylene glycol monomethyl ether acetate, methyl ethyl ketone, acetone, methyl isobutyl ketone, ethyl acetate, butyl acetate, ethyl lactate, *N,N*-dimethylacetamide, *N*-methylpyrrolidone, and dimethyl sulfoxide.

Specific preferred examples of the protic organic solvent include methanol, ethanol, 1-propanol, 2-propanol, 1-butanol, 1-methoxy-2-propanol, ethylene glycol, diethylene glycol, and 1,3-propanediol.

Among them, propylene glycol monomethyl ether acetate is particularly preferable.

The content of Component E in the resin composition for laser engraving is preferably no greater than 10 mass% relative to the total solids content, more preferably no greater than 1 mass%, yet more preferably no greater than 0.1 mass%, and the resin composition particularly preferably contains no solvent.

<Other additives>

The resin composition for laser engraving of the present invention may comprise as appropriate various types of known additives as long as the effects of the present invention are not inhibited. Examples include a plasticizer, a filler, a wax, a process oil, an a metal oxide, an antiozonant, an anti-aging agent, a thermopolymerization inhibitor, and a colorant, and one type thereof may be used on its own or two more types may be used in combination.

<Compositional ratio of components>

Relative to the total mass of the resin composition for laser engraving, the content of Component A is preferably 15 to 60 mass%, the content of Component B is preferably 50 to 95 mass%, the content of Component C is preferably at least 0.01 mass%, the content of Component D is preferably 0.01 to 30 mass%, the content of Component E is preferably 0 to 2 mass%, and the content of the solvent is preferably 0 to 10 mass%.

(Flexographic printing plate precursor for laser engraving and process for making same)

A first embodiment of the flexographic printing plate precursor for laser engraving of the present invention comprises a relief-forming layer formed from the resin composition for laser engraving of the present invention.

A second embodiment of the flexographic printing plate precursor for laser engraving of the present invention comprises a crosslinked relief-forming layer formed by crosslinking a relief-forming layer formed from the resin composition for laser engraving of the present invention.

In the present invention, the 'flexographic printing plate precursor for laser engraving' means both or one of a plate having a crosslinkable relief-forming layer formed from the resin composition for laser engraving in a state before being crosslinked and a plate in a state in which it is cured by light and/or heat.

In the present invention, the 'relief-forming layer' means a layer in a state before being crosslinked, that is, a layer formed from the resin composition for laser engraving of the present invention, which may be dried as necessary.

When a printing plate precursor having a crosslinked relief-forming layer is laser-engraved, the "flexographic printing plate" is produced.

In the present invention, the 'crosslinked relief-forming layer' means a layer formed by crosslinking the relief-forming layer. The crosslinking is preferably carried out by means of heat. Furthermore, the crosslinking is not particularly limited as long as it is a reaction by which the resin composition is cured, and it is a concept that includes a structure crosslinked due to reactions between Component B and Component C, but it is preferable to form a crosslinked structure by a reaction between Component B and other Component.

The 'flexographic printing plate' is prepared by laser engraving a printing plate precursor having a crosslinked relief-forming layer.

Moreover, in the present invention, the 'relief layer' means a layer of the flexographic printing plate formed by engraving using a laser, that is, the crosslinked relief-forming layer after laser engraving.

The flexographic printing plate precursor for laser engraving of the present invention comprises a relief-forming layer comprising a resin composition for laser engraving comprising the components as described above, or a crosslinked relief-forming layer that is formed by crosslinking a layer comprising a resin composition for laser engraving comprising the components as described above. The relief-forming layer and the crosslinked relief-forming layer are preferably provided above a support.

The flexographic printing plate precursor for laser engraving may further comprise, as necessary, an adhesive layer between a support and the relief-forming layer or the crosslinked relief-forming layer, and a slip coat layer and a protective film above the relief-forming layer or the crosslinked relief-forming layer.

<Relief-forming layer>

The relief-forming layer is a layer formed from the resin composition for laser engraving of the present invention and is preferably a heat-crosslinkable layer.

As a mode in which a flexographic printing plate is prepared using the flexographic printing plate precursor for laser engraving, a mode in which a flexographic printing plate is prepared by crosslinking a relief-forming layer to thus form a flexographic printing plate precursor having a crosslinked relief-forming layer, and the crosslinked relief-forming layer (hard relief-forming layer) is then laser-engraved to thus form a relief layer is preferable. By crosslinking the relief-forming layer, it is possible to prevent abrasion of the relief layer during printing, and it is possible to obtain a flexographic printing plate having a relief layer with a sharp shape after laser engraving.

The relief-forming layer may be formed by molding the resin composition for laser engraving that has the above-mentioned components for a relief-forming layer into a sheet shape or a sleeve shape. The relief-forming layer is usually provided above a support, which is described later, but it may be formed directly on the surface of a member such as a cylinder of equipment for plate making or printing or may be placed and immobilized thereon, and a support is not always required.

A case in which the relief-forming layer is mainly formed in a sheet shape is explained as an example below.

<Support>

A material used for the support of the flexographic printing plate precursor for laser engraving is not particularly limited, but one having high dimensional stability is preferably used, and examples thereof include metals such as steel, stainless steel, or aluminum, plastic resins such as a polyester (e.g. PET (polyethylene terephthalate), PBT (polybutylene terephthalate), or PAN (polyacrylonitrile)) or polyvinyl chloride, synthetic rubbers such as styrene-butadiene rubber, and glass fiber-reinforced plastic resins (epoxy resin, phenolic resin, etc.). As the support, a PET film or a steel substrate is preferably used. The configuration of the support depends on whether the relief-forming layer is in a sheet shape or a sleeve shape.

<Adhesive layer>

An adhesive layer may be provided between the relief-forming layer and the support for the purpose of strengthening the adhesion between the two layers. Examples of materials (adhesives) that can be used in the adhesive layer include those described in 'Handbook of Adhesives', Second Edition, Ed by I. Skeist, (1977).

<Protection film, slip coat layer>

For the purpose of preventing scratches or dents in the relief-forming layer surface or the crosslinked relief-forming layer surface, a protection film may be provided on the relief-forming layer surface or the crosslinked relief-forming layer surface. The thickness of the protection film is preferably 25 to 500 $\mu$m, and more preferably 50 to 200 $\mu$m. The protection film may employ, for example, a polyester-based film such as PET or a polyolefin-based film such as PE (polyethylene) or PP (polypropylene). The surface of the film may be made matte. The protection film is preferably peelable.

When the protection film is not peelable or conversely has poor adhesion to the relief-forming layer, a slip coat layer may be provided between the two layers. The material used in the slip coat layer preferably employs as a main component a resin that is soluble or dispersible in water and has little tackiness, such as polyvinyl alcohol, polyvinyl acetate, partially saponified polyvinyl alcohol, a hydroxyalkylcellulose, an alkylcellulose, or a polyamide resin.

Furthermore, the volume fraction of Component A in the relief-forming layer or the crosslinked relief-forming layer is preferably 25 to 85%, more preferably 30 to 75%, and yet more preferably 30 to 65%.

The volume fraction is given by the equation below using measurements obtained by a scanning electron microscope (SEM) for the number and the area of micro cavities contained in a range of 0.5 mm $\times$ 0.5 mm at any position of a cross-section of a relief layer cut in a direction perpendicular to the film surface.

$$\text{Volume fraction (\%) = (area} \times \text{number of micro cavities)}/(0.25 \text{ mm}^2) \times 100$$

Formation of a relief-forming layer in the flexographic printing plate precursor for laser engraving is not particularly limited, and examples thereof include a method in which the resin composition for laser engraving is prepared, solvent is removed as necessary from this resin composition for laser engraving, and it is melt-extruded onto a support. Alternatively, a method may be employed in which the resin composition for laser engraving is cast onto a support, and this is dried in an oven to thus remove solvent from the resin composition.

Among them, the process for making a flexographic printing plate for laser engraving of the present invention is preferably a production process comprising a kneading step of kneading the resin composition for laser engraving of the present invention, a layer formation step of forming the kneaded material obtained into a sheet shape to thus form a relief-forming layer, and a crosslinking step of crosslinking by means of heat the relief-forming layer to thus give a flexographic printing plate precursor having a crosslinked relief-forming layer.

Subsequently, as necessary, a protection film may be laminated on the relief-forming layer. Laminating may be carried out by compression-bonding the protection film and the relief-forming layer by means of heated calendar rollers, etc. or putting a protection film into intimate contact with a relief-forming layer whose surface is impregnated with a small amount of solvent.

When a protection film is used, a method in which a relief-forming layer is first layered on a protection film and a support is then laminated may be employed.

When an adhesive layer is provided, it may be dealt with by use of a support coated with an adhesive layer. When a slip coat layer is provided, it may be dealt with by use of a protection film coated with a slip coat layer.

<Kneading step>

The process for producing a flexographic printing plate precursor for laser engraving of the present invention preferably comprises a kneading step of kneading the resin composition for laser engraving of the present invention.

In this step, components contained in the resin composition for laser engraving of the present invention are mixed, melted by heating, and kneaded until uniform, thus preparing a kneaded material.

As equipment used for kneading, there can be cited for example a kneader, a dissolver, a mixer, a high-speed disperser, a sand mill, a roll mill, a ball mill, an attritor, a bead mill, etc.

The kneaded material may be produced by for example a method in which Component A to Component D are kneaded, and optional components, etc. are further kneaded in sequence or a method in which Component A, Component B, Component D, optional components, etc. are kneaded in advance and Component C is then added and further kneaded, but a method that does not use a solvent is preferable. Since it is preferable to remove most of a solvent component in a stage in which a flexographic printing plate precursor is produced, it is preferable to use a volatile low-molecular-weight alcohol (e.g. methanol, ethanol, *n*-propanol, isopropanol, propylene glycol monomethyl ether), etc. as the solvent, and adjust the temperature, etc. so that the total amount of solvent added is as little as possible.

The heating temperature during kneading is selected according to components such as the polymer used, but it is preferably carried out in the range of 60°C to 120°C, and more preferably 60°C to 80°C. When the heating temperature is within this range, a kneaded material in which the Component A contained therein maintains its hollow shape is obtained.

Furthermore, from the viewpoint of mixing each component uniformly, the kneading time is preferably in the range of 30 minutes to 6 hours.

<Layer formation step>

The process for producing a flexographic printing plate precursor for laser engraving of the present invention preferably comprises a layer formation step of forming the kneaded material obtained into a sheet shape to thus give a relief-forming layer.

As a method for forming a relief-forming layer, a method in which the kneaded material prepared in the kneading step is rubber-extruded onto a support, a method in which the solvent is removed from the kneaded material as necessary and the kneaded material is then melt-extruded onto a support, a method in which the kneaded material is cast onto a support, and this is dried in an oven to thus remove the solvent, and a method in which a heat treatment is carried out by heated platen pressing (hereinafter, also called a 'hot pressing method') can be cited as preferred examples.

Among them, it is preferable to form a relief-forming layer without using a solvent by means of thermal molding by a melt-extrusion method, a rubber extrusion method, a hot pressing method, etc.

The thickness of the (crosslinked) relief-forming layer in the flexographic printing plate precursor for laser engraving before and after crosslinking is preferably at least 0.05 mm but no greater than 10 mm, more preferably at least 0.05 mm but no greater than 7 mm, and yet more preferably at least 0.05 mm but no greater than 3 mm.

<Crosslinking step>

The process for producing a flexographic printing plate precursor for laser engraving of the present invention preferably comprises a crosslinking step of crosslinking a relief-forming layer by means of heat to thus obtain a flexographic printing plate precursor comprising a crosslinked relief-forming layer.

In the crosslinking step, crosslinking is preferably carried out by means of heat.

The heating temperature in the crosslinking step may be set freely according to the decomposition temperature of the peroxide, etc.; it is preferably 90°C to 250°C, more preferably 100°C to 180°C, yet more preferably 100°C to 160°C, and particularly preferably 120°C to 140°C. With this mode, it is possible to easily carry out crosslinking by means of heat at the same time.

As heating means in the crosslinking step, there can be cited a method in which a printing plate precursor is heated in a hot air oven or a far infrared oven for a predetermined time or a method in which it is put in contact with a heated roll for a predetermined time.

Moreover, the support may be peeled off from the crosslinked relief-forming layer after the crosslinking step, or from the viewpoint of strength and smoothness the support provided during the crosslinking step may be peeled off from the crosslinked relief-forming layer and subsequently another support may be provided on the side of the crosslinked relief-forming layer where the above support has been provided or the side opposite thereto.

(Flexographic printing plate and process for making same)

The process for making a flexographic printing plate of the present invention preferably comprises a preparation step of preparing the flexographic printing plate precursor of the present invention and an engraving step of laser-engraving the flexographic printing plate precursor comprising the crosslinked relief-forming layer.

The flexographic printing plate of the present invention is a flexographic printing plate comprising a relief layer obtained by crosslinking and laser-engraving a layer comprising the resin composition for laser engraving of the present invention, and is preferably a flexographic printing plate made by the process for making a flexographic printing plate of the present invention.

The preparation step in the process for making a flexographic printing plate of the present invention is preferably the layer formation step and the crosslinking step described above, and these steps are the same as the layer formation step and the crosslinking step in the process for producing a flexographic printing plate precursor for laser engraving, preferred ranges also being the same.

<Engraving step>

The process for making a flexographic printing plate of the present invention preferably comprises an engraving step of laser-engraving the flexographic printing plate precursor having a crosslinked relief-forming layer.

The engraving step is a step of laser-engraving a crosslinked relief-forming layer that has been crosslinked in the crosslinking step to thus form a relief layer. Specifically, it is preferable to engrave a crosslinked relief-forming layer that has been crosslinked by irradiation with laser light according to a desired image, thus forming a relief layer. Furthermore, a step in which a crosslinked relief-forming layer is subjected to scanning irradiation by controlling a laser head using a computer in accordance with digital data of a desired image can preferably be cited.

This engraving step preferably employs an infrared laser. When irradiated with an infrared laser, molecules in the crosslinked relief-forming layer undergo molecular vibration, thus generating heat. When a high power laser such as a carbon dioxide laser or a YAG laser is used as the infrared laser, a large quantity of heat is generated in the laser-irradiated area, and molecules in the crosslinked relief-forming layer undergo molecular scission or ionization, thus being selectively removed, that is, engraved. The advantage of laser engraving is that, since the depth of engraving can be set freely, it is possible to control the structure three-dimensionally. For example, for an area where fine halftone dots are printed, carrying out engraving shallowly or with a shoulder prevents the relief from collapsing due to printing pressure, and for a groove area where a fine outline character is printed, carrying out engraving deeply makes it difficult for ink the groove to be blocked with ink, thus enabling breakup of an outline character to be suppressed.

In particular, when engraving is carried out using an infrared laser that corresponds to the absorption wavelength of the photothermal conversion agent, it becomes possible to selectively remove the crosslinked relief-forming layer at higher sensitivity, thus giving a relief layer having a sharp image.

As the infrared laser used in the engraving step, from the viewpoint of productivity, cost, etc., a carbon dioxide laser (a $CO_2$ laser) or a semiconductor laser is preferable. In particular, a fiber-coupled semiconductor infrared laser (FC-LD) is preferably used. In general, compared with a $CO_2$ laser, a semiconductor laser has higher efficiency laser oscillation, is less expensive, and can be made smaller. Furthermore, it is easy to form an array due to the small size. Moreover, the shape of the beam can be controlled by treatment of the fiber.

With regard to the semiconductor laser, one having a wavelength of 700 to 1,300 nm is preferable, one having a wavelength of 800 to 1,200 nm is more preferable, one having a wavelength of 860 to 1,200 nm is futher preferable, and one having a wavelength of 900 to 1,100 nm is particularly preferable.

Furthermore, the fiber-coupled semiconductor laser can output laser light efficiently by being equipped with optical fiber, and this is effective in the engraving step in the present invention. Moreover, the shape of the beam can be controlled by treatment of the fiber. For example, the beam profile may be a top hat shape, and energy can be applied stably to the plate face. Details of semiconductor lasers are described in 'Laser Handbook 2nd Edition' The Laser Society of Japan, and 'Applied Laser Technology' The Institute of Electronics and Communication Engineers, etc.

Moreover, as plate making equipment comprising a fiber-coupled semiconductor laser that can be used suitably in the process for making a flexographic printing plate employing the flexographic printing plate precursor of the present invention, those described in detail in JP-A-2009-172658 and JP-A-2009-214334 can be cited.

The process for making a flexographic printing plate of the present invention may as necessary further comprise, subsequent to the engraving step, a rinsing step, a drying step, and/or a post-crosslinking step, which are shown below.

Rinsing step: a step of rinsing the engraved surface by rinsing the engraved relief layer surface with water or a liquid containing water as a main component.

Drying step: a step of drying the engraved relief layer.

Post-crosslinking step: a step of further crosslinking the relief layer by applying energy to the engraved relief layer.

After the above steps, a rinsing step of washing off engraving residue by rinsing the engraved surface with water or a liquid containing water as a main component may be added. Examples of rinsing means include a method in which washing is carried out with tap water, a method in which high pressure water is spray-jetted, and a method in which the engraved surface is brushed in the presence of mainly water using a known batch or conveyor brush type washout machine, and when slime due to engraving residue cannot be eliminated, a rinsing liquid to which a soap or a surfactant is added may be used.

When the rinsing step of rinsing the engraved surface is carried out, it is preferable to add a drying step of drying an engraved relief-forming layer so as to evaporate rinsing liquid.

Furthermore, as necessary, a post-crosslinking step for further crosslinking the relief-forming layer may be added. By carrying out a post-crosslinking step, which is an additional crosslinking step, it is possible to further strengthen the relief formed by engraving.

A rinsing liquid that can be used in the present invention is preferably a rinsing liquid having a pH of 8 to 14. With this embodiment, rinsing properties for engraving residue generated when laser engraving are excellent.

Furthermore, the pH of the rinsing liquid that can be used in the present invention is more preferably at least 9, yet more preferably at least 10, and particularly preferably at least 11. Moreover, the pH of the rinsing liquid is more preferably no greater than 13.5, and yet more preferably no greater than 13.2. With this range, handling is easy, and rinsing properties for engraving residue generated when laser engraving are excellent.

In order to make the rinsing liquid have a pH in this range, the pH may be adjusted using an acid and/or a base as appropriate; the acid and the base used are not particularly limited. From the viewpoint of cost, etc., it is preferable to use as the base the hydroxide of an alkali metal or an alkaline earth metal.

The rinsing liquid that can be used in the present invention is preferably an aqueous rinsing liquid that contains water as a main component.

The rinsing liquid may comprise, as a solvent other than water, a water-miscible solvent such as an alcohol, acetone, or tetrahydrofuran.

The rinsing liquid preferably comprises a surfactant.

From the viewpoint of removability of engraving residue and little influence on a flexographic printing plate, preferred examples of the surfactant that can be used in the present invention include amphoteric surfactants such as a carboxybetaine compound, a sulfobetaine compound, a phosphobetaine compound, an amine oxide compound, and a phosphine oxide compound.

Furthermore, examples of the surfactant also include known anionic surfactants, cationic surfactants, and nonionic surfactants. Moreover, a fluorine-based or silicone-based nonionic surfactant may also be used in the same manner.

With regard to the surfactant, one type may be used on its own or two or more types may be used in combination.

It is not necessary to particularly limit the amount of surfactant used, but it is preferably 0.01 to 20 mass % relative to the total weight of the rinsing liquid, and more preferably 0.05 to 10 mass %.

The flexographic printing plate of the present invention having a relief layer on the surface of any substrate such as a surpport etc. may be produced as described above.

From the viewpoint of satisfying suitability for various aspects of printing, such as abrasion resistance and ink transfer properties, the thickness of the relief layer of the flexographic printing plate is preferably at least 0.05 mm but no greater than 10 mm, more preferably at least 0.05 mm but no greater than 7 mm, and yet more preferably at least 0.05 mm but no greater than 3 mm.

Furthermore, the Shore A hardness of the relief layer of the flexographic printing plate is preferably at least 50° but no greater than 90°. When the Shore A hardness of the relief layer is at least 50°, even if fine halftone dots formed by engraving receive a strong printing pressure from a letterpress printer, they do not collapse and close up, and normal printing can be carried out. Furthermore, when the Shore A hardness of the relief layer is no greater than 90°, even for flexographic printing with kiss touch printing pressure it is possible to prevent patchy printing in a solid printed part.

The Shore A hardness in the present specification is a value measured at 25°C by a durometer (a spring type rubber hardness meter) that presses an indenter (called a pressing needle or indenter) into the surface of a measurement target so as to deform it, measures the amount of deformation (indentation depth), and converts it into a numerical value.

The flexographic printing plate of the present invention is particularly suitable for printing in a flexographic printer using an aqueous ink, but printing is also possible in a letterpress printer when using any ink such as an aqueous ink, an oil-based ink, or a UV ink, and printing is also possible in a flexographic printer using a UV ink. The flexographic printing plate of the present invention is excellent in terms of rinsing properties and leaves no engraving residue, and since the relief layer that is obtained has excellent elasticity the aqueous ink transfer properties and durability are excellent, and printing can be carried out without worries about plastic deformation of the relief layer or degradation of durability over long time periods.

EXAMPLE

The present invention is explained more specifically below by reference to Examples and Comparative Examples. However, the present invention should not be construed as being limited by these Examples. In the description below, 'parts' means 'parts by mass' and '%' means 'mass%' unless otherwise specified. Furthermore, the units of each of the numerical values in Table 1 below are parts by mass.

The number-average molecular weight (Mn) and weight-average molecular weight (Mw) of polymers in the Examples are values measured by the GPC method unless otherwise specified.

Details of components used in the Examples and Comparative Examples are as follows.

<Hollow crosslinked particles>

MHB-R: hollow particles (methyl methacrylate crosspolymer, Matsumoto Yushi Seiyaku Co., Ltd.)

SX866 (A): hollow particles (crosslinked styrene-acrylic polymer, JSR)

SX8782 (P): hollow particles (crosslinked styrene-acrylic polymer, JSR)

SX8782 (D): hollow particles (styrene-acrylic polymer, JSR), those used were dried at normal temperature under normal pressure for 24 hours and then dried at 60°C under reduced pressure for 10 hours.

M-305: smooth surface spherical particles (methyl methacrylate crosspolymer, Matsumoto Yushi Seiyaku Co., Ltd.)

F-30SV: thermally expandable microcapsules (vinylidene chloride-acrylonitrile-based copolymer, Matsumoto Yushi Seiyaku Co., Ltd.)

C-1504: spherical fine powder silica (Fuji Silysia Chemical Ltd.)

<Binder polymers>

BR150L: polybutadiene (UBEPOL BR150L, Mooney viscosity ($ML_{1+4}$, 100°C): 43, Mw: 467,000, Mn: 243,000, Tg: about -103°C, tensile set: 63%, Ube Industries, Ltd.) IR2200L: polyisoprene (NIPOL IR2200L, Mooney viscosity ($ML_{1+4}$, 100°C): 70, Mw: 1,350,000, Mn: 472,000, Tg: about -60°C, tensile set: 53%, Nippon Zeon Corporation)

D-1102: styrene-butadiene-styrene block copolymer (Kraton D-1102, SBS resin, Mw: 100,000, tensile set: 0%, Kraton)

TR2000: SBR (styrene butadiene rubber, Tg = -50°C, 100°C, Mw = 56,000, JSR) BUTYL365: butyl rubber (isobutylene-isoprene copolymer, Mw = 260,000, JSR)

<Synthesis of PU-1>

A three-necked flask equipped with a condenser was charged with 200 parts of a mixture of Poly bd R-45HT (polybutadienediol, Idemitsu Kosan Co., Ltd.) and isophorone diisocyanate (Wako Pure Chemical Industries, Ltd.) (weights mixed being adjusted to give NCO/OH molar ratio = 1.05), while stirring under an atmosphere of nitrogen at normal temperature (25°C, the same applies below) 0.1 parts of Neostann U-600 (inorganic bismuth-based catalyst, Nitto Chemical Industry Co., Ltd.) was added as a urethane reaction catalyst, and stirring was carried out at normal temperature for a further 30 minutes. Subsequently, the reaction solution was heated and stirred at 80°C for 5 hours, 1 part of 1-methoxy-2-propanol (Wako Pure Chemical Industries, Ltd.) was added, and heating and stirring were carried out for a further 1 hour. As a result of the above procedure, polyurethane PU-1 having a polybutadiene chain was obtained as a highly viscous liquid. Identification of the polymer was carried out using GPC (Mw = 56,000), NMR, and IR.

<Synthesis of PU-2>

Polyurethane acrylate PU-2 having a polybutadiene chain was obtained as a highly viscous liquid in the same manner as for the synthesis of PU-1 except that 1 part of 1-methoxy-2-propanol was changed to 1 part of 2-hydroxyethyl acrylate (Wako Pure Chemical Industries, Ltd.). Identification of the polymer was carried out using GPC (Mw = 56,000), NMR, and IR.

<Peroxide>

PCD-40: dicumyl peroxide (Percumyl D-40, organic peroxide, containing 40% of dicumyl peroxide, 10 hour half-life temperature: 116.4°C, NOF Corporation) Irgacure 651 (IRGACURE 651, photopolymerization initiator, 2-phenyl-2,2-dimethoxyacetophenone, BASF)

<Polymerizable compound>

HDDA: hexanediol diacrylate (Tokyo Chemical Industry Co., Ltd.)

<Photothermal conversion agent>

#45L: carbon black #45L (particle size : 24nm, specific surface area: 125 $m^2$/g, DBP oil adsorption: 45 mL/100 g, Mitsubishi Chemical Corporation)

(Examples 1 to 11 and Comparative Examples 2 to 6)

<Preparation of flexographic printing plate precursor for laser engraving>

Based on the materials and formulations described in Table 1 and Table 2 below, the respective materials other than the polymerization initiator were kneaded in a Labo Plastomill (Toyo Seiki Co., Ltd.) (60°C, 20 minutes). Subsequently, peroxide was added, and kneading (80°C, 5 minutes) was further carried out to thus give a resin composition for laser engraving. The resin composition thus obtained was molded into a 1 mm thick sheet using a rubber extruder, and this sheet was placed in a heating oven and heated at 140°C for 80 minutes to thus carry out crosslinking, thereby giving a flexographic printing plate precursor for laser engraving.
The notation '-' in Table 1 and Table 2 means that the corresponding component was not used.

<Preparation of flexographic printing plate>

The crosslinked resin composition layer (crosslinked relief-forming layer) was subjected to laser engraving using the two types of laser below.
For engraving by irradiation with a laser, as a carbon dioxide laser engraving machine an ML-9100 series high quality $CO_2$ laser marker (Keyence) was used. A 1 cm square solid printed area was raster-engraved using the carbon dioxide laser engraving machine under conditions of an output of 12 W, a head speed of 200 mm/sec, and a pitch setting of 2,400 DPI.
As a semiconductor laser engraving machine, laser recording equipment provided with an SDL-6390 fiber-coupled semiconductor laser (FC-LD) (JDSU, wavelength 915 nm) with a maximum power of 8.0 W was used. A 1 cm square solid printed area was raster-engraved using the semiconductor laser engraving machine under conditions of a laser output of 7.5 W, a head speed of 409 mm/sec, and a pitch setting of 2,400 DPI.
The engraving machines used are shown in Table 2. Here, 'FC-LD' means use of the semiconductor laser engraving machine and '$CO_2$' means use of the carbon dioxide laser engraving machine.

(Comparative Example 1)

Based on the materials and formulations described in Table 1 and Table 2 below, the respective materials other than the polymerization initiator were kneaded in a Labo Plastomill (Toyo Seiki Co., Ltd.) (60°C, 20 minutes). Subsequently, the polymerization initiator was added, and kneading (80°C, 5 minutes) was further carried out to thus give a resin composition for laser engraving. The resin composition thus obtained was molded into a 1 mm thick sheet using a rubber extruder, and this sheet was subjected to UV exposure using UV (UV) exposure equipment installed in a hot plate while heating at 100°C for 80 minutes to thus carry out crosslinking, thereby giving a flexographic printing plate precursor for laser engraving.
The flexographic printing plate precursor for laser engraving thus obtained was subjected to laser engraving as in Example 1, thus giving a flexographic printing plate.

-Evaluation of flexographic printing plate precursor for laser engraving and flexographic printing plate-

The performance of the flexographic printing plate precursors for laser engraving and the flexographic printing plates obtained in the Examples and Comparative Examples was evaluated with respect to the items below. The evaluation results are given in Table 3.

<Evaluation of film surface state>

A 30 cm × 30 cm size film of the flexographic printing plate precursor was subjected to visual examination for the film surface state and evaluated.

1: the film surface was uniform and completely free from irregularities, dents, and bulges.
2: the film surface had less than five irregularities, dents, or bulges.
3: the film surface had five or more irregularities, dents, or bulges.

<Evaluation of film thickness precision>

A 30 cm × 30 cm size flexographic plate precursor (after being made into a film) was subjected to measurement of film thickness at a total of 90 positions at intervals of 1 cm lengthwise and widthwise using calipers, and the difference between the maximum value and the minimum value for the thickness was defined as the film thickness precision and evaluated.

1: film thickness precision was less than 30 μm.
2: film thickness precision was at least 30 μm but less than 100 μm.
3: film thickness precision was 100 μm or greater.

<Evaluation of engraving sensitivity (engraving depth)>

The 'engraving depth' of the relief layer obtained by laser engraving a crosslinked relief-forming layer of the flexographic printing plate precursor was measured as follows. The 'engraving depth' referred to here means the difference between an engraved position (height) and an unengraved position (height) when a cross-section of the relief layer was examined. The 'engraving depth' in the present Examples was measured by examining a cross-section of a relief layer using a VK9510 Ultradepth Color 3D profile measurement microscope (Keyence Corporation). A large engraving depth means a high engraving sensitivity.

<Evaluation of rinsing properties>

A laser-engraved plate was immersed in water and an engraved part was rubbed with a toothbrush (Clinica Toothbrush Flat, Lion Corporation) 10 times. Subsequently, the presence/absence of residue on the surface of the relief layer was ascertained with an optical microscope. When there was no residue the evaluation was 1, when there was a little residue but there was no problem in practice the evaluation was 2, and when the residue could not be removed sufficiently the evaluation was 3.

<Evaluation of engraved shape>

Under the same conditions as those for the evaluation of engraving sensitivity above, a single line with a width of 2 cm was engraved. Subsequently, the film was cut using a cutter in a direction perpendicular to the engraving direction for the line, and the exposed film cross-section was examined using an optical microscope. When the ratio of depth and width (depth/width) of an engraved portion (bowl shape) was at least 0.8, it was evaluated as 1, and when it was less than 0.8, it was evaluated as 2.

<Evaluation of image quality>

A two pixel halftone dot was formed by laser engraving and then loaded on a printer, and printing was carried out on a polypropylene sheet. The halftone dot on the printed material was examined using a microscope; when the area of the two pixel halftone dot was less than 1.1 times the area of apexes of the halftone dot formed, it was evaluated as 1, and when it was 1.1 times or greater, it was evaluated as 3.

<Evaluation of printing durability>

A flexographic printing plate that was obtained was set in a printer (Model ITM-4, Iyo Kikai Seisakusho). As the ink a solvent ink (XS-716 507 Blue (DIC GRAPHICS CORPORATION)) was used. Printing was continued using as print paper Full Color Form M 70 (Nippon Paper Group, Inc., thickness 100 μm), 1% to 10% highlights being checked for the printed material. Completion of printing was defined as being when halftone dots were not printed, and the length (km) of paper printed up to the completion of printing was used as an index. The larger the value, the better the evaluation of printing durability.

table 1

| Example | Hollow crosslinked particles | Binder polymer | Peroxide | Photothermal conversion agent | Polymerizable compound |
|---------|------------------------------|----------------|----------|-------------------------------|------------------------|
| Ex. 1 | MHB-R | BR150L | PCD-40 | #45L | - |

(continued)

| Example | Hollow crosslinked particles | Binder polymer | Peroxide | Photothermal conversion agent | Polymerizable compound |
|---|---|---|---|---|---|
| Ex. 2 | MHB-R | BR150L | PCD-40 | #45L | - |
| Ex. 3 | SX866 (A) | BR150L | PCD-40 | #45L | - |
| Ex. 4 | SX8782 (P) | BR150L | PCD-40 | #45L | - |
| Ex. 5 | MHB-R | IR2200L | PCD-40 | #45L | - |
| Ex. 6 | MHB-R | D-1102 | PCD-40 | #45L | - |
| Ex. 7 | MHB-R | TR2000 | PCD-40 | #45L | - |
| Ex. 8 | MHB-R | BUTYL365 | PCD-40 | #45L | - |
| Ex. 9 | MHB-R | Polybutadiene-containing polyurethane (PU-1) | PCD-40 | #45L | - |
| Ex. 10 | MHB-R | Polybutadiene-containing polyurethane acrylate (PU-2) | PCD-40 | #45L | - |
| Ex. 11 | MHB-R | BR150L | PCD-40 | #45L | HDDA |
| Comp. Ex. 1 | MHB-R | BR150L | Irgacure651 | - | HDDA |
| Comp. Ex. 2 | M-305 | BR150L | PCD-40 | #45L | - |
| Comp. Ex. 3 | SX8782(D) | BR150L | PCD-40 | #45L | - |
| Comp. Ex. 4 | F-30SV | BR150L | PCD-40 | #45L | - |
| Comp. Ex. 5 | - | BR150L | PCD-40 | #45L | - |
| Comp. Ex. 6 | F-30SV C-1504 | Polybutadiene-containing polyurethane acrylate (PU-2) | PCD-40 | #45L | HDDA |

table 2

| (Parts by mass) | Hollow crosslinked particles | Binder polymer | Peroxide | Photothermal conversion agent | Polymerizable compound | Total |
|---|---|---|---|---|---|---|
| Ex. 1 | 5 | 89 | 1 | 5 | - | 100 |
| Ex. 2 | 30 | 64 | 1 | 5 | - | 100 |
| Ex. 3 | 30 | 64 | 1 | 5 | - | 100 |
| Ex. 4 | 30 | 64 | 1 | 5 | - | 100 |
| Ex. 5 | 30 | 64 | 1 | 5 | - | 100 |
| Ex. 6 | 30 | 64 | 1 | 5 | - | 100 |
| Ex. 7 | 30 | 64 | 1 | 5 | - | 100 |
| Ex. 8 | 30 | 64 | 1 | 5 | - | 100 |
| Ex. 9 | 30 | 64 | 1 | 5 | - | 100 |
| Ex. 10 | 30 | 64 | 1 | 5 | - | 100 |

(continued)

| (Parts by mass) | Hollow crosslinked particles | Binder polymer | Peroxide | Photothermal conversion agent | Polymerizable compound | Total |
|---|---|---|---|---|---|---|
| Ex. 11 | 30 | 54 | 1 | 5 | 10 | 100 |
| Comp. Ex. 1 | 30 | 59 | 1 | - | 10 | 100 |
| Comp. Ex. 2 | 30 | 64 | 1 | 5 | - | 100 |
| Comp. Ex. 3 | 30 | 64 | 1 | 5 | - | 100 |
| Comp. Ex. 4 | 30 | 64 | 1 | 5 | - | 100 |
| Comp. Ex. 5 | - | 94 | 1 | 5 | - | 100 |
| Comp. Ex. 6 | F-30SV: 1.5 C-1504: 5 | 80 | 1 | 5 | 7.5 | 100 |

table 3

| Ex. | Film surface condition | Film thickness precision | Film thickness (μm) | $CO_2$ laser engraving depth (μm) | FC-LD engraving depth (μm) | Engraved shape | Image quality | Rinsing properties | Printing durability |
|---|---|---|---|---|---|---|---|---|---|
| Ex. 1 | 1 | 1 | 25 μm | 620 μm | 700 μm | 1 | 1 | 1 | 82 km |
| Ex. 2 | 1 | 1 | 25 μm | 640 μm | 715 μm | 1 | 1 | 1 | 84 km |
| Ex. 3 | 1 | 1 | 20 μm | 625 μm | 710 μm | 1 | 1 | 1 | 82 km |
| Ex. 4 | 1 | 1 | 20 μm | 625 μm | 710 μm | 1 | 1 | 1 | 82 km |
| Ex. 5 | 1 | 1 | 25 μm | 590 μm | 690 μm | 1 | 1 | 1 | 75 km |
| Ex. 6 | 1 | 1 | 25 μm | 580 μm | 680 μm | 1 | 1 | 1 | 65 km |
| Ex. 7 | 1 | 1 | 25 μm | 585 μm | 690 μm | 1 | 1 | 1 | 60 km |
| Ex. 8 | 1 | 1 | 25 μm | 560 μm | 650 μm | 1 | 1 | 1 | 60 km |
| Ex. 9 | 1 | 1 | 25 μm | 540 μm | 640 μm | 1 | 1 | 1 | 55 km |
| Ex. 10 | 1 | 1 | 25 μm | 540 μm | 640 μm | 1 | 1 | 1 | 55 km |
| Ex. 11 | 2 | 2 | 45 μm | 610 μm | 685 μm | 1 | 1 | 1 | 82 km |
| Comp. Ex. 1 | 2 | 2 | 40 μm | 480 μm | Engraving not possible | 2 | 3 | 2 | 50 km |
| Comp. Ex. 2 | 1 | 1 | 25 μm | 480 μm | 500 μm | 1 | 1 | 2 | 80 km |
| Comp. Ex. 3 | 3 | 3 | 130 μm | 500 μm | 525 μm | 1 | 1 | 3 | 50 km |
| Comp. Ex. 4 | 3 | 3 | 200 μm | 490 μm | 520 μm | 1 | 1 | 3 | 40 km |
| Comp. Ex. 5 | 1 | 1 | 25 μm | 490 μm | 520 μm | 1 | 1 | 3 | 30 km |
| Comp. Ex. 6 | 3 | 3 | 300 μm | 470 μm | 490 μm | 1 | 1 | 3 | 40 km |

**Claims**

1. A resin composition for laser engraving, comprising
   as Component A hollow crosslinked particles comprising in a polymer layer a crosslinked polymer comprising a (meth)acrylic acid ester-derived monomer unit and/or a styrene-derived monomer unit,
   as Component B a binder polymer,
   as Component C a peroxide, and
   as Component D a photothermal conversion agent.

2. The resin composition for laser engraving according to Claim 1, wherein Component A has a content of 15 to 60 mass% relative to the total mass of the solids content of the resin composition for laser engraving.

3. The resin composition for laser engraving according to Claim 1 or 2, wherein it comprises as Component E substantially none of a polymerizable compound.

4. The resin composition for laser engraving according to any one of Claims 1 to 3, wherein Component A has a volume-average particle size of primary particles of 0.01 μm to 50 μm.

5. The resin composition for laser engraving according to any one of Claims 1 to 4, wherein Component A is of at least one type of hollow crosslinked particles selected from the group consisting of MHB-R and M-600 manufactured by Matsumoto Yushi Seiyaku Co., Ltd. and SX866 (A), SX868 (B), SX8782 (A), and SX8782 (P) manufactured by JSR.

6. The resin composition for laser engraving according to any one of Claims 1 to 4, wherein the crosslinked polymer of which Component A is comprised is a copolymer of divinylbenzene and a polyvalent (meth)acrylic acid ester compound or a copolymer of a polyvalent (meth)acrylic acid ester compound and a monovalent (meth)acrylic acid ester compound.

7. The resin composition for laser engraving according to any one of Claims 1 to 6, wherein Component B is a polymer having a conjugated diene-based hydrocarbon-derived monomer unit.

8. The resin composition for laser engraving according to any one of Claims 1 to 7, wherein Component B is a polymer having a butadiene- and/or isoprene-derived monomer unit.

9. The resin composition for laser engraving according to any one of Claims 1 to 8, wherein Component B is a plastomer at 20°C.

10. A flexographic printing plate precursor for laser engraving comprising a relief-forming layer comprising the resin composition for laser engraving according to any one of Claims 1 to 9.

11. A flexographic printing plate precursor for laser engraving comprising a crosslinked relief-forming layer formed by crosslinking by means of heat a relief-forming layer comprising the resin composition for laser engraving according to any one of Claims 1 to 9.

12. A process for producing a flexographic printing plate precursor for laser engraving, comprising
    a kneading step of kneading the resin composition for laser engraving according to any one of Claims 1 to 9,
    a layer formation step of forming the kneaded material obtained into a sheet shape to thus form a relief-forming layer, and
    a crosslinking step of crosslinking by means of heat the relief-forming layer to thus give a flexographic printing plate precursor having a crosslinked relief-forming layer.

13. A process for making a flexographic printing plate, comprising
    a step of preparing the flexographic printing plate precursor for laser engraving according to Claim 10 or 11 or a flexographic printing plate precursor for laser engraving produced by the production process according to Claim 12, and
    an engraving step of laser-engraving the relief-forming layer or the crosslinked relief-forming layer to thus form a relief layer.

14. The process for making a flexographic printing plate according to Claim 13, wherein it further comprises, subsequent to the engraving step, a rinsing step of rinsing the crosslinked relief layer surface using an aqueous rinsing liquid.

15. A flexographic printing plate obtained by the process for making a flexographic printing plate according to Claim 13 or 14.

**Patentansprüche**

1. Harzzusammensetzung für die Lasergravur, umfassend
als Komponente A, hohle vernetzte Partikel, umfassend in einer Polymerschicht ein vernetztes Polymer, das eine aus einem (Meth)acrylsäureester abgeleitete Monomereinheit und/oder eine aus Styrol abgeleitete Monomereinheit umfasst,
als Komponente B, ein Bindepolymer,
als Komponente C, ein Peroxid und
als Komponente D, ein Foto-Wärme-Umwandlungsmittel.

2. Harzzusammensetzung für die Lasergravur gemäß Anspruch 1, worin die Komponente A einen Mengenanteil von 15 bis 60 Masse% aufweist, relativ zur Gesamtmasse der festen Bestandteile der Harzzusammensetzung für die Lasergravur.

3. Harzzusammensetzung für die Lasergravur gemäß Anspruch 1 oder 2, worin sie als Komponente E wesentlich nichts von einer polymerisierbaren Verbindung umfasst.

4. Harzzusammensetzung für die Lasergravur gemäß irgendeinem der Ansprüche 1 bis 3, worin die Komponente A eine volumengemittelte Partikelgröße der Primärpartikel von 0,01 μm bis 50 μm aufweist.

5. Harzzusammensetzung für die Lasergravur gemäß irgendeinem der Ansprüche 1 bis 4, worin die Komponente A mindestens eine Art von hohlen vernetzten Partikeln ist, ausgewählt ist aus der Gruppe, bestehend aus MHB-R und M-600, hergestellt von Matsumoto Yushi Seiyaku Co., Ltd., und SX866 (A), SX868 (B), SX8782 (A) und SX8782 (P), hergestellt von JSR.

6. Harzzusammensetzung für die Lasergravur gemäß irgendeinem der Ansprüche 1 bis 4, worin das vernetzte Polymer, das in der Komponente A umfasst ist, ein Copolymer von Divinylbenzol und einer polyvalenten (Meth)acrylsäureesterverbindung oder ein Copolymer einer polyvalenten (Meth)acrylsäureesterverbindung und einer monovalenten (Meth)acrylsäureesterverbindung ist.

7. Harzzusammensetzung für die Lasergravur gemäß irgendeinem der Ansprüche 1 bis 6, worin die Komponente B ein Polymer mit einer auf konjugiertem Dien basierenden, aus Kohlenwasserstoff abgeleiteter Monomereinheit ist.

8. Harzzusammensetzung für die Lasergravur gemäß irgendeinem der Ansprüche 1 bis 7, worin die Komponente B ein Polymer mit einer aus Butadien- und/oder Isoprenabgeleiteten Monomereinheit ist.

9. Harzzusammensetzung für die Lasergravur gemäß irgendeinem der Ansprüche 1 bis 8, worin die Komponente B bei 20°C ein Plastomer ist.

10. Flexographie-Druckplattenvorläufer für die Lasergravur, umfassend eine Relief-bildende Schicht, die die Harzzusammensetzung für die Lasergravur gemäß irgendeinem der Ansprüche 1 bis 9 umfasst.

11. Flexographie-Druckplattenvorläufer für die Lasergravur, umfassend eine vernetzte Relief-bildende Schicht, die durch Vernetzen durch Wärme einer Relief-bildenden Schicht gebildet ist, die die Harzzusammensetzung für die Lasergravur gemäß irgendeinem der Ansprüche 1 bis 9 umfasst.

12. Verfahren zur Herstellung eines Flexographie-Druckplattenvorläufers für die Lasergravur, umfassend
einen Knetschritt zum Kneten der Harzzusammensetzung für die Lasergravur gemäß irgendeinem der Ansprüche 1 bis 9,
einen Schichtbildungsschritt zum Formen des erhaltenen gekneteten Materials zu einer Lagenform, um somit eine Relief-bildende Schicht zu bilden, und
einen Vernetzungsschritt zum Vernetzen mittels Wärme der Relief-bildenden Schicht, um somit einen Flexographie-Druckplattenvorläufer zu erhalten, der eine vernetzte Relief-bildende Schicht aufweist.

13. Verfahren zur Herstellung einer Flexographiedruckplatte, umfassend
einen Schritt zur Herstellung eines Flexographie-Druckplattenvorläufers für die Lasergravur gemäß Anspruch 10 oder 11 oder eines Flexographie-Druckplattenvorläufers für die Lasergravur, der mit dem Herstellungsverfahren gemäß Anspruch 12 hergestellt ist, und
einen Gravurschritt zum Lasergravieren der Relief-bildenden Schicht oder der vernetzten Relief-bildenden Schicht, um somit eine Reliefschicht zu bilden.

14. Verfahren zur Herstellung einer Flexographiedruckplatte gemäß Anspruch 13, welches ferner im Anschluss an den Gravurschritt einen Spülschritt zum Spülen der vernetzten Reliefschichtoberfläche unter Verwendung einer wässrigen Spülflüssigkeit umfasst.

15. Flexographiedruckplatte, erhalten durch das Verfahren zur Herstellung einer Flexographie-Druckplatte gemäß Anspruch 13 oder 14.

**Revendications**

1. Composition de résine pour une gravure au laser, comprenant
en tant que Composant A, des particules réticulées creuses comprenant dans une couche de polymère un polymère réticulé comprenant un motif monomère dérivé d'un ester d'acide (méth)acrylique et/ou un motif monomère dérivé de styrène,
en tant que Composant B, un polymère liant,
en tant que Composant C, un peroxyde, et
en tant que Composant D, un agent de conversion photothermique.

2. Composition de résine pour une gravure au laser selon la revendication 1, dans laquelle le Composant A a une teneur de 15 à 60 % en masse par rapport à la masse totale des matières solides dans la composition de résine pour une gravure au laser.

3. Composition de résine pour une gravure au laser selon la revendication 1 ou 2, dans laquelle elle comprend, en tant que Composant E, essentiellement aucun composé polymérisable.

4. Composition de résine pour une gravure au laser selon l'une quelconque des revendications 1 à 3, dans laquelle le Composant A a une taille de particules moyenne en volume des particules primaires de 0,01 $\mu$m à 50 $\mu$m.

5. Composition de résine pour une gravure au laser selon l'une quelconque des revendications 1 à 4, dans laquelle le Composant A est d'au moins un type de particules réticulées creuses choisies dans le groupe constitué de MHB-R et M-600, fabriquées par Matsumoto Yushi Seiyaku Co., Ltd., et SX866 (A), SX868 (B), SX8782 (A) et SX8782 (P), fabriquées par JSR.

6. Composition de résine pour une gravure au laser selon l'une quelconque des revendications 1 à 4, dans laquelle le polymère réticulé dont est constitué le Composant A est un copolymère de divinylbenzène et d'un composé d'ester d'acide (méth)acrylique polyvalent ou un copolymère d'un composé d'ester d'acide (méth)acrylique polyvalent et d'un composé d'ester d'acide (méth)acrylique monovalent.

7. Composition de résine pour une gravure au laser selon l'une quelconque des revendications 1 à 6, dans laquelle le Composant B est un polymère comprenant un motif monomère dérivé d'un hydrocarbure à base d'un diène conjugué.

8. Composition de résine pour une gravure au laser selon l'une quelconque des revendications 1 à 7, dans laquelle le Composant B est un polymère comprenant un motif monomère dérivé de butadiène et/ou d'isoprène.

9. Composition de résine pour une gravure au laser selon l'une quelconque des revendications 1 à 8, dans laquelle le Composant B est un plastomère à 20 C.

10. Précurseur de plaque d'impression flexographique pour une gravure au laser comprenant une couche de formation de relief comprenant la composition de résine pour une gravure au laser selon l'une quelconque des revendications 1 à 9.

11. Précurseur de plaque d'impression flexographique pour une gravure au laser comprenant une couche de formation de relief réticulée formée par réticulation, au moyen de chaleur, d'une couche de formation de relief comprenant la composition de résine pour une gravure au laser selon l'une quelconque des revendications 1 à 9.

12. Procédé de production d'un précurseur de plaque d'impression flexographique pour une gravure au laser, comprenant
une étape de pétrissage consistant à pétrir la composition de résine pour une gravure au laser selon l'une quelconque des revendications 1 à 9,
une étape de formation de couche consistant à donner au matériau pétri obtenu une forme de feuille, pour ainsi former une couche de formation de relief, et
une étape de réticulation consistant à réticuler, au moyen de chaleur, la couche de formation de relief pour donner ainsi un précurseur de plaque d'impression flexographique portant une couche de formation de relief.

13. Procédé de fabrication d'une plaque d'impression flexographique, comprenant
une étape consistant à préparer le précurseur de plaque d'impression flexographique pour une gravure au laser selon la revendication 10 ou 11 ou un précurseur de plaque d'impression flexographique pour une gravure au laser produit par le procédé de production selon la revendication 12, et
une étape de gravure consistant à graver au laser la couche de formation de relief ou la couche de formation de relief réticulée, pour ainsi former une couche en relief.

14. Procédé de fabrication d'une plaque d'impression flexographique selon la revendication 13, dans lequel il comprend en outre, après l'étape de gravure, une étape de rinçage consistant à rincer la surface de la couche en relief réticulée à l'aide d'un liquide de rinçage aqueux.

15. Plaque d'impression flexographique obtenue par le procédé de fabrication d'une plaque d'impression flexographique selon la revendication 13 ou 14.

# EP 2 913 185 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007272080 A
- EP 2597108 A
- WO 2013016044 A
- JP 2011136455 A
- JP 2010208326 A
- JP 2012045801 A
- JP 2008063554 A
- JP 2009178869 A
- JP 46027926 B
- JP 51047334 B
- JP 57196231 A
- JP 59005240 A
- JP 59005241 A
- JP 2226149 A
- JP 1165613 A
- JP 54021726 B
- JP 48041708 B
- JP 51037193 A
- JP 2032293 B

- JP 2016765 B
- JP 58049860 B
- JP 56017654 B
- JP 62039417 B
- JP 62039418 B
- JP 63277653 A
- JP 63260909 A
- JP 1105238 A
- JP 48064183 A
- JP 49043191 B
- JP 52030490 B
- JP 46043946 B
- JP 1040337 B
- JP 1040336 B
- JP 2025493 A
- JP 61022048 A
- JP 2009204962 A
- JP 2009172658 A
- JP 2009214334 A

**Non-patent literature cited in the description**

- New Polymer Dictionary. *the Society of Polymer Science, Japan,* 1988
- Senryo Binran. *The Society of Synthetic Organic Chemistry, Japan,* 1970
- Handbook, 'Saishin Ganryo Binran. Latest Pigments Handbook. 1977

- Saisin Ganryo Ouyogijutsu. Latest Applications of Pigment Technology. CMC Publishing, 1986
- Insatsu Inki Gijutsu. Printing Ink Technology. CMC Publishing, 1984
- *Journal of the Adhesion Society of Japan,* 1984, vol. 20 (7), 300-308
- Handbook of Adhesives. 1977